# EUROPÄISCHE PATENTSCHRIFT

(11) **EP 3 743 583 B1**
(45) Veröffentlichungstag und Bekanntmachung des Hinweises auf die Patenterteilung: **26.01.2022**
(21) Anmeldenummer: 19700599.4
(22) Anmeldetag: 16.01.2019
(51) Int. Cl.: E06B 3/663

(54) **ABSTANDHALTER FÜR ISOLIERVERGLASUNGEN MIT IN HOHLKAMMER INTEGRIERTER ELEKTRISCHER ZULEITUNG**
SPACER FOR INSULATED GLAZING UNITS WITH ELECTRICAL WIRE INTEGRATED IN HOLLOW CHAMBER
DISPOSITIF D'ÉCARTEMENT POUR VITRAGES ISOLANTS DOTÉ D'UNE CONDUITE D'ALIMENTATION ÉLECTRIQUE INTÉGRÉE DANS UNE CHAMBRE CREUSE

(30) Priorität: 22.01.2018 EP 18152707
(43) Veröffentlichungstag der Anmeldung: 02.12.2020
(73) Patentinhaber: SAINT-GOBAIN GLASS FRANCE, 92400 Courbevoie (FR)
(72) Erfinder: NEANDER, Marcus, 52249 Eschweiler (DE); MORVAN, Guenael, 13009 Marseille (FR); KUSTER, Hans-Werner, 52066 AACHEN (DE); MARJAN, Christopher, 52072 Aachen (DE)
(74) Vertreter: Schönen, Iris
(86) Internationale Anmeldenummer: PCT/EP2019/050992
(87) Internationale Veröffentlichungsnummer: WO 2019/141700

(56) Entgegenhaltungen:
- DE-A1- 3 330 305
- US-A- 4 306 140
- US-A- 4 691 486

## Beschreibung

Die Erfindung betrifft einen Abstandhalter mit integrierter elektrischer Zuleitung eine Isolierverglasung umfassend einen solchen Abstandhalter, ein Verfahren zu dessen Herstellung und dessen Verwendung.

Isolierverglasungen sind vor allem im Zuge immer strengerer Umweltschutzauflagen nicht mehr aus dem Gebäudebau wegzudenken. Diese werden dabei aus mindestens zwei Scheiben gefertigt, die über mindestens einen umlaufenden Abstandshalter miteinander verbunden sind. Je nach Ausführungsform ist der als Verglasungsinnenraum bezeichnete Zwischenraum der beiden Scheiben luft- oder gasgefüllt, in jedem Fall jedoch frei von Feuchtigkeit. Ein zu hoher Gehalt an Feuchtigkeit im Verglasungszwischenraum führt besonders bei kalten Außentemperaturen zur Kondensation von Wassertropfen im Scheibenzwischenraum, was unbedingt zu vermeiden ist. Zur Aufnahme der nach der Montage im System verbleibenden Restfeuchtigkeit können beispielsweise mit einem Trockenmittel gefüllte Hohlkörperabstandshalter verwendet werden. Da die Aufnahmekapazität des Trockenmittels jedoch begrenzt ist, ist auch in diesem Fall die Abdichtung des Systems von enormer Wichtigkeit um das Eindringen weiterer Feuchtigkeit zu vermeiden.

Isolierverglasungen können über ihre grundsätzliche Funktion hinausgehend auch weitere Elemente in Form von Einbauten oder Scheiben mit steuerbaren Zusatzfunktionen enthalten. Eine Art von modernen, aktiven Verglasungen sind Verglasungen mit schaltbaren oder regelbaren optischen Eigenschaften. Bei solchen Verglasungen kann beispielsweise die Transmission von Licht in Abhängigkeit einer angelegten elektrischen Spannung aktiv beeinflusst werden. Der Benutzer kann beispielsweise von einen transparenten in einen nicht transparenten Zustand der Verglasung schalten, um den Einblick in einen Raum von außen zu verhindern. Bei anderen Verglasungen kann die Transmission stufenlos geregelt werden, beispielsweise um den Eintrag von Sonnenenergie in einem Raum zu regulieren. Dadurch wird eine unerwünschte Erwärmung von Gebäuden oder Fahrzeuginnenräumen vermieden und der durch Klimaanlagen verursachte Energieverbrauch bzw. CO₂-Ausstoß reduziert. Aktive Verglasungen dienen folglich nicht nur der optisch ansprechenden Gestaltung von Fassaden und einer angenehmen Lichtgestaltung in Innenräumen, sondern sind auch unter energetischen und ökologischen Gesichtspunkten vorteilhaft.

Aktive Verglasungen enthalten ein Funktionselement, welches typischerweise eine aktive Schicht zwischen zwei Flächenelektroden enthält. Die optischen Eigenschaften der aktiven Schicht können durch eine an die Flächenelektroden angelegte Spannung verändert werden. Ein Beispiel hierfür sind elektrochrome Funktionselemente, die beispielsweise aus US 20120026573 A1 und WO 2012007334 A1 bekannt sind. Ein weiteres Beispiel sind SPD-Funktionselemente (suspended particle device), die beispielsweise aus EP 0876608 B1 und WO 2011033313 A1 bekannt sind. Durch die angelegte Spannung lässt sich die Transmission von sichtbarem Licht durch elektrochrome oder SPD-Funktionselemente steuern. Die Spannungszufuhr erfolgt über sogenannte Sammelleiter (bus bars), die in der Regel auf den Flächenelektroden aufgebracht sind und über geeignete Verbindungskabel mit einer Spannungsquelle verbunden sind.

Wird eine aktive Verglasung in einer Isolierverglasung integriert, so ist die Spannungszufuhr der aktiven Verglasung gas- und wasserdicht auszugestalten um eine hinreichende Qualität und Lebensdauer der Isolierverglasung zu gewährleisten. In WO 2017/106458 A1 wird die elektrische Zuleitung selbst in Form und Größe so gestaltet, dass diese eine höhere Toleranz gegen Relativbewegungen bei unterschiedlicher thermischer Ausdehnung der beteiligten Komponenten aufweist. Die Zuleitung selbst erfolgt jedoch zwischen Abstandhalter und benachbarter Scheibe durch das zur Verklebung und Abdichtung dienende primäre Dichtmittel. Eine derartige Kabeldurchführung durch den Randverbund der Isolierverglasung stellt immer auch eine potenzielle Fehlstelle dar.

Darüber hinaus ist in der Praxis häufig eine elektrische Kontaktierung an mehreren Stellen der Isolierverglasung notwendig. Dabei wird das Anschlusskabel nach dem Stand der Technik im äußeren Scheibenzwischenraum um den Abstandhalterrahmen herumgeführt. Der Abstandhalter ist über ein sogenanntes primäres Dichtmittel mit den Scheiben der Isolierverglasung verklebt, während im äußeren Scheibenzwischenraum ein sekundäres Dichtmittel eingebracht ist, das diesen ausfüllt und eventuell vorhandene elektrische Anschlusskabel umgibt. Das automatisierte Verfüllen des äußeren Scheibenzwischenraums in Gegenwart elektrischer Anschlusskabel erweist sich jedoch als problematisch, da diese beispielsweise einen Roboterarm mit Extrusionsdüse räumlich behindern können. Ferner dürfen keine Luftblasen im äußeren Scheibenzwischenraum verbleiben, beispielsweise zwischen Anschlusskabel und Abstandhalter. Das Volumen der eingeschlossenen Luft variiert mit sich ändernden klimatischen Bedingungen und führt dauerhaft zu Undichtigkeiten der Isolierverglasung im Bereich des Lufteinschlusses.

Um eine verbesserte Dichtigkeit von Isolierverglasungen zu gewährleisten sind bereits die verschiedensten Modifikationen im Bereich der Abstandhalter bekannt. Eine Maßnahme zur Verbesserung der Dichtigkeit von Isolierverglasungen ist die Beschichtung von polymeren Abstandhaltern mit Metallfolien oder alternierenden Metall-Polymer-Schichtsystemen, wie beispielsweise in EP 0 852 280 A1 und WO 2013/104507 A1 offenbart. Diese gewährleisten eine hohe Dichtigkeit des Abstandhalters bei gleichzeitiger Kompatibilität mit den zur Montage verwendeten Dichtstoffen. Die genannten Probleme hinsichtlich der Dichtigkeit von Isolierverglasungen mit elektrischen Zuleitungen werden davon allerdings nicht berührt.

In DE 3330305 A1 ist ein Fenster mit einer im Rahmen gehaltenen Verbundglasscheibe beschrieben, wobei die Verbundscheibe eine elektrisch steuerbares Flüssigkristallelement umfasst. Die Ansteuerschaltung wird von einem Akkumulator gespeist, der über eine Solarzellenanordnung nachgeladen wird.

US 4306140 beschäftigt sich mit dem Problem der elektrischen Kontaktierung einer transparenten leitfähigen Beschichtung über den Randverbund einer Kühlregalverglasung, wobei der physikalische Kontakt mit stromführenden Teilen bei Bruch der Verglasung verhindert werden soll.

US 4691486 A1 beschreibt eine Isolierverglasung mit einer heizbaren Scheibe umfassend einen Randverbund mit Hohlprofilabstandhaltern, die an den Ecken über Eckverbinder verbunden sind, wobei die elektrische Kontaktierung der heizbaren Scheibe über den Randverbund mittels einer Kabeldurchführung in den Eckverbindern erfolgt.

Aufgabe der vorliegenden Erfindung ist es, einen Abstandhalter, der zu einer verbesserten Abdichtung von Isolierverglasungen mit elektrischen Zuleitungen führt, eine Isolierverglasung mit diesem Abstandshalter, sowie ein wirtschaftliches Verfahren zur Herstellung der Isolierverglasung bereitzustellen.

Die Aufgabe der vorliegenden Erfindung wird erfindungsgemäß durch einen Abstandhalter mit integrierter elektrischer Zuleitung, eine Isolierverglasung mit Abstandhalter, ein Verfahren zu deren Herstellung und der Verwendung des Abstandhalters nach den unabhängigen Ansprüchen 1, 11 und 13 gelöst. Bevorzugte Ausführungen der Erfindung gehen aus den Unteransprüchen hervor.

Der erfindungsgemäße Abstandhalter mit integrierter elektrischer Zuleitung für Isolierverglasungen umfasst mindestens einen Grundkörper umfassend zwei Scheibenkontaktflächen, eine Verglasungsinnenraumfläche, eine Außenfläche und mindestens eine Hohlkammer. Die elektrische Zuleitung verläuft innerhalb der Hohlkammer des Abstandhalters. Dabei verläuft die elektrische Zuleitung nach Eintritt in die Hohlkammer in mindestens einem Abschnitt längs der Hohlkammer innerhalb dieser Hohlkammer. Längs der Hohlkammer ist in diesem Sinne als in Längsrichtung der Hohlkammer, also im Wesentlichen parallel zu den Scheibenkontaktflächen, zu verstehen. Durch mindestens eine Austrittsöffnung in der Wandung des Grundkörpers tritt die elektrische Zuleitung wieder aus der Hohlkammer aus. Der Grundkörper (5) ist ein polymerer Grundkörper und die elektrische Zuleitung (14) ist an der Innenwandung des polymeren Grundkörpers (5) stoffschlüssig angebunden.

Der erfindungsgemäße Abstandhalter ermöglicht eine industriell automatisierbare Weiterverarbeitung eines Abstandhalterrahmens umfassend den erfindungsgemäßen Abstandhalter. Da die Zuleitung innerhalb der Hohlkammer geführt wird, kann eine automatisierte Verfüllung des Randbereichs der Verglasung erfolgen, ohne dass die elektrische Zuleitung ein Hindernis für eine entlang der Außenseite des Abstandhalters geführte Materialdüse darstellt. Ferner ist die Zuleitung mit Ausnahme der Stelle, an der diese in den Grundkörper eintritt oder aus diesem austritt, nicht von außen sichtbar und somit auch optisch unauffällig integriert.

Im Sinne der Erfindung wird der Abstandhalter mit integrierter elektrischer Zuleitung insbesondere dann angewandt, wenn beispielsweise eine Spannungsversorgung an mehreren Stellen der Isolierverglasung notwendig ist und die zwischen diesen Stellen liegende Entfernung mittels eines elektrischen Leiters überbrückt werden muss.

Der erfindungsgemäße Aufbau stellt ferner eine wesentliche Verbesserung im Hinblick auf die Dichtigkeit von Isolierverglasungen dar. Nach dem Stand der Technik werden elektrische Zuleitungen zwischen einer der Scheibenkontaktflächen und der benachbarten Scheibe innerhalb des Dichtmittels, das diese Komponenten miteinander verklebt, in den Verglasungsinnenraum geführt. Jegliche Kabeldurchführung stellt dabei eine potentielle Undichtigkeit dar, da Hohlräume in Nachbarschaft zum Kabel verbleiben können, die durch thermische Ausdehnung der enthaltenen Luft zu einer Undichtigkeit führen. Der erfindungsgemäße Abstandhalter ermöglicht hingegen eine vorteilhafte Reduzierung der Kabeldurchführungen. Eine elektrische Zuleitung muss nur einmalig in die Hohlkammer des Abstandhalters eingeführt werden, kann entlang des Abstandhalterrahmens der Verglasung geführt werden und an jeder beliebigen Stelle der Verglasung, an der eine Spannungsversorgung erforderlich ist, aus dem Grundkörper des Abstandhalters herausgeführt werden. Somit ist nur eine einzelne Eintrittstelle der Zuleitung abzudichten, selbst wenn an diversen Positionen der Isolierverglasung ein Kabel in den Verglasungsinnenraum zu führen ist.

Ein wesentlicher Vorteil der Erfindung liegt auch im hohen Vorfertigungsgrad des erfindungsgemäßen Abstandhalters mit integrierter elektrischer Zuleitung. Die Leitungen werden dabei bereits im Fertigungsprozess des Abstandhalters in diesem integriert, so dass während der Herstellung der Isolierverglasung keine manuelle Installation der Zuleitungen mehr erforderlich ist. Bei Herstellung der Isolierverglasung sind die bereits im Grundkörper des Abstandhalters vorhandenen Zuleitungen lediglich an den erforderlichen Stellen aus dem Grundkörper herauszuführen. Dazu kann der Grundkörper beispielsweise mit einem Bohrloch versehen werden, durch das die Zuleitungen aus dem Abstandhalter gezogen werden. Da die manuelle Installation der Zuleitungen entfällt, kann der Automatisierungsgrad der Isolierglasherstellung weiter erhöht werden.

Die Hohlkammer grenzt an die Verglasungsinnenraumfläche, wobei die Verglasungsinnenraumfläche sich oberhalb der Hohlkammer befindet und die Außenfläche des Abstandhalters sich unterhalb der Hohlkammer befindet. Oberhalb ist in diesem Zusammenhang als dem inneren Scheibenzwischenraum der Isolierverglasung zugewandt und unterhalb als dem Scheibeninnenraum abgewandt definiert.

Die Hohlkammer des Abstandhalters der erfindungsgemäßen Isolierverglasung führt zu einer Gewichtsreduktion im Vergleich zu einem massiv ausgeformten Abstandhalter und steht zur Aufnahme von weiteren Komponenten, wie beispielsweise eines Trockenmittels, zur Verfügung.

Die erste Scheibenkontaktfläche und die zweite Scheibenkontaktfläche stellen die Seiten des Abstandhalters dar, an denen beim Einbau des Abstandhalters die Montage der äußeren Scheiben (erste Scheibe und zweite Scheibe) einer Isolierverglasung erfolgt. Die erste Scheibenkontaktfläche und die zweite Scheibenkontaktfläche verlaufen parallel zueinander.

Die Verglasungsinnenraumfläche ist als die Fläche des Abstandhaltergrundkörpers definiert, die nach Einbau des Abstandhalters in einer Isolierverglasung in Richtung des Innenraums der Verglasung weisen. Die Verglasungsinnenraumfläche liegt dabei zwischen der ersten und der zweiten Scheibe.

Die Außenfläche des Abstandhaltergrundkörpers ist die der Verglasungsinnenraumfläche gegenüberliegende Seite, die vom Innenraum der Isolierverglasung weg in Richtung einer äußeren Versiegelung weist.

Die Außenfläche des Abstandhalters kann in einer möglichen Ausführungsform jeweils benachbart zu den Scheibenkontaktflächen abgewinkelt sein, wodurch eine erhöhte Stabilität des Grundkörpers erzielt wird. Die Außenfläche kann benachbart zu den Scheibenkontaktflächen beispielsweise um jeweils 30-60°, relativ zur Außenfläche, abgewinkelt sein.

In einer bevorzugten Ausführungsform tritt die elektrische Zuleitung durch eine Eintrittsöffnung in der Außenfläche des Abstandhalters in die Hohlkammer ein. Die Positionierung der Eintrittsöffnung an der Außenfläche des Abstandhalters ist vorteilhaft, da an dieser Stelle eine im wesentlichen ebene Fläche zur Verfügung steht, die auf einfache Art und Weise nach Durchführung des Kabels wieder abdichtbar ist.

In einer anderen bevorzugten Ausführungsform tritt die elektrische Zuleitung durch einen offenen Querschnitt des Grundkörpers in die Hohlkammer ein. In diesem Fall wird die Zuleitung an einem offenen Ende des Abstandhalters in die Hohlkammer geführt. Dabei wird vorzugsweise eine Stelle gewählt, an der ein Eckverbinder oder ein Längsverbinder in den Abstandhalter eingesteckt ist und diesen mit einem weiteren Abstandhalter verbindet. Die Zuleitung wird dabei gemeinsam mit einem Schenkel des Verbinders in den offenen Querschnitt des Grundkörpers eingesteckt. Falls dies erforderlich ist, kann der Schenkel des Verbinders eine Aussparung aufweisen, die es ermöglicht die Zuleitung und den Verbinder ohne räumliche Behinderung der Bauteile in das offene Ende des Abstandhalters einzuführen. Um eine möglichst hohe Dichtigkeit zu erreichen wird auch in dieser Ausführungsform die Eintrittsstelle der Zuleitung mit einem Dichtmittel abgedichtet.

In einer bevorzugten Ausführungsform des Hohlprofilabstandhalters umfasst dieser einen polymeren Grundkörper. Dies ist vorteilhaft, da die Wärmeleitfähigkeit von Kunststoffen wesentlich geringer ist als die Wärmeleitfähigkeit von Metallen. Des Weiteren weist der Kunststoff des polymeren Grundkörpers einen spezifischen Widerstand von mindestens 10⁸ Ω cm auf und ist somit nichtleitend für elektrischen Strom. Dies ist besonders vorteilhaft, da die elektrische Zuleitung in diesem Fall keiner weiteren Isolierung bedarf und der polymere Grundkörper die Zuleitung ausreichend gegenüber weiteren Bauteilen isoliert.

Optional kann auch der polymere Grundkörper eine elektrische Zuleitung mit einer die Zuleitung umgebenden Isolierung aufweisen. Dies ist beispielsweise vorteilhaft um mehrere in der Hohlkammer verlaufende Zuleitungen unterschiedlicher Polaritäten gegeneinander zu isolieren.

Die elektrische Zuleitung verläuft bevorzugt in mindestens einem Abschnitt mit einer Länge von mindestens 10 cm, bevorzugt mindestens 20 cm, besonders bevorzugt mindestens 30 cm innerhalb der Hohlkammer. Dieser Abstand befindet sich demnach mindestens zwischen der Eintrittsöffnung und der davon am weitesten entfernten Austrittsöffnung, gemessen entlang der Längsrichtung des Grundkörpers parallel zu den Scheibenkontaktflächen. Die Vorteile der Erfindung kommen besonders zum Tragen, wenn längere Abschnitte einer frei im äußeren Scheibenzwischenraum liegenden Zuleitung vermieden werden können, da diese im weiteren Verarbeitungsprozess der Isolierverglasung besonders hinderlich sind. Die elektrische Zuleitung ist ein elektrischer Leiter, bevorzugt enthaltend Kupfer. Es können auch andere elektrisch leitende Materialien verwendet werden. Beispiele hierfür sind Aluminium, Gold, Silber oder Zinn und Legierungen davon. Die elektrische Zuleitung kann sowohl als Flachleiter als auch als Rundleiter ausgestaltet sein, sowie in beiden Fällen als eindrähtiger oder mehrdrähtiger Leiter (Litze).

Die elektrische Zuleitung besitzt bevorzugt einen Leitungsquerschnitt von 0,08 mm² bis 2,5 mm².

Als Zuleitung können auch Folienleiter verwendet werden. Beispiele für Folienleiter werden in DE 42 35 063 A1, DE 20 2004 019 286 U1 und DE 93 13 394 U1 beschrieben.

Flexible Folienleiter, mitunter auch Flachleiter oder Flachbandleiter genannt, bestehen bevorzugt aus einem verzinnten Kupferband mit einer Dicke von 0,03 mm bis 0,1 mm und einer Breite von 2 mm bis 16 mm. Kupfer hat sich für solche Leiterbahnen bewährt, da es eine gute elektrische Leitfähigkeit sowie eine gute Verarbeitbarkeit zu Folien besitzt. Gleichzeitig sind die Materialkosten niedrig.

Bevorzugt umfasst der Abstandhalter einen polymeren Grundkörper, in den die elektrische Zuleitung bereits bei Extrusion des Abstandhalters eingebracht wird. Der Grundkörper wird dabei um die elektrische Zuleitung extrudiert. Dies ist besonders vorteilhaft hinsichtlich einer einfachen und kostengünstigen Herstellung des Abstandhalters und einer automatisierten Integration der Zuleitung in den Grundkörper.

In einer besonders bevorzugten Ausführungsform wird die elektrische Zuleitung bereits bei Extrusion des Abstandhalters in den polymeren Grundkörper eingelegt, wobei die elektrische Zuleitung an der Innenwandung des polymeren Grundkörpers stoffschlüssig angebunden ist. Dabei kann die elektrische Zuleitung beispielsweise bei Extrusion in die Oberfläche des noch nicht erstarrten Material des polymeren Grundkörpers eingebracht werden, so dass nach Erstarren des Kunststoffs eine stoffschlüssige Verbindung besteht. Alternativ dazu kann die an den Grundkörper grenzende Oberfläche der elektrischen Zuleitung mit einer Kleberschicht versehen werden, die die elektrische Zuleitung an den Grundkörper anbindet. Dazu verläuft die elektrische Zuleitung beispielsweise über eine Kleberwalze und wird anschließend mit dem polymeren Grundkörper umschlossen. Diese Ausführungsformen sind hinsichtlich einer Befüllung des Hohlraums des polymeren Grundkörpers mit Trockenmittel vorteilhaft. Die elektrischen Zuleitungen liegen unmittelbar an der Wandung des Grundkörpers an, so dass das Trockenmittel ohne Hinderung eingefüllt werden kann und die Bildung von Hohlräumen ohne Trockenmittel vermieden wird. Des Weiteren erhalten die elektrischen Zuleitungen auf diese Weise eine definierte Position innerhalb des Grundkörpers. Dies ist hinsichtlich einer elektrischen Kontaktierung der Zuleitungen vorteilhaft. Auf diese Weise kann die Zuleitung beispielsweise an der der Außenfläche benachbarten Innenwandung des Grundkörpers angebracht werden und ein elektrischer Kontaktstift von der Außenfläche ausgehend durch die Wandung des polymeren Grundkörpers hindurch in die elektrische Zuleitung eingebracht werden. Auf diese Weise wird gleichzeitig eine Eintrittsöffnung der Zuleitung geschaffen und die elektrische Kontaktierung vorgenommen. Zur Kontaktierung mittels eines elektrischen Kontaktstiftes eignen sich insbesondere bandförmige Leiter (beispielsweise Folienleiter), da diese ein Einstecken des Kontaktstiftes erleichtern. Der elektrische Kontaktstift bildet dabei selbst einen Abschnitt der elektrischen Zuleitung. Die Materialien des Kontaktstiftes werden demnach in der Regel aus den möglichen Materialien der restlichen elektrischen Zuleitung ausgewählt. Der elektrische Kontaktstift wird jedoch aus einem massiven Material ausgeführt um ein Einpressen in den polymeren Grundkörper zu erleichtern. Eine elektrische Kontaktierung der im Hohlraum befindlichen Zuleitung von Seiten des inneren Scheibenzwischenraums kann analog zum hier Beschriebenen ebenfalls über einen Kontaktstift ausgeführt sein. Das in den inneren bzw. äußeren Scheibenzwischenraum ragende Ende eines Kontaktstiftes kann eine verbreiterte Oberfläche, beispielsweise in Form einer Metallplatte, besitzen, die eine Möglichkeit zur Anbindung von Zuleitungen bietet. Eine solche Oberfläche kann beispielsweise als Lötfläche zur Anbindung eines Kabels dienen, das den elektrischen Verbraucher bzw. die Spannungsquelle kontaktiert.

In einer bevorzugten Ausführungsform übersteigt die Länge der elektrischen Zuleitung die Länge des Abstandhalters, in den die Zuleitung integriert ist. Dies ist vorteilhaft um die Zuleitung an einer Eintrittsöffnung und/oder Austrittsöffnung aus dem Grundkörper herausziehen zu können. Bevorzugt ist die Länge der elektrischen Zuleitung mindestens 5%, besonders bevorzugt mindestens 10% länger als die Länge des Abstandhalters, in den die Zuleitung integriert ist. Es hat sich herausgestellt, dass dies ausreicht um das Herausführen der Zuleitung aus dem Abstandhalter zu erleichtern und um genügend Material entlang des Abstandhalters zur Verfügung zu stellen. Die Zuleitung kann bündig mit dem offenen Querschnitt des Abstandhalters enden, wobei die Zuleitung innerhalb der Hohlkammer beispielsweise in Schleifen verlegt ist um die längere Zuleitung in den kürzeren Abstandhalter zu integrieren. Wahlweise kann die elektrische Zuleitung auch bei Bereitstellung des Abstandhalters aus dem offenen Querschnitt des Abstandhalters herausragen.

Die elektrische Zuleitung ist geeignet um an einem Ende mit einer Spannungsversorgung verbunden zu werden und an einem anderen Ende mit einem elektrischen Verbraucher kontaktiert zu werden. Nach Montage des erfindungsgemäßen Abstandhalters in einer Isolierverglasung liegt die Spannungsversorgung dabei außerhalb des Verglasungsinnenraums und der elektrische Verbraucher innerhalb des Verglasungsinnenraums.

Die elektrische Zuleitung tritt durch eine Austrittsöffnung in den Verglasungsinnenraum ein. Die Austrittsöffnung ist dabei bevorzugt in der Verglasungsinnenraumfläche und/oder in mindestens einer der Scheibenkontaktflächen angebracht. Eine Austrittsöffnung in der Verglasungsinnenraumfläche hat den Vorteil, dass diese nicht mit einem Dichtmittel verschlossen werden muss, da ein Gasaustausch zwischen der Hohlkammer des Abstandhalters und dem Verglasungsinnenraum in der Regel erwünscht ist. Darüber hinaus wird die Verklebung zwischen Abstandhalter und benachbarten Scheiben nicht durch die Leitungsführung beeinträchtigt. Eine Austrittsöffnung an einer der Scheibenkontaktflächen ist hingegen vorteilhaft um die Austrittsöffnung optisch zu kaschieren und diese an einer möglichst unauffälligen Stelle zu positionieren.

Da die elektrische Zuleitung stoffschlüssig an der Innenwandung eines polymeren Grundkörpers angebunden ist, bietet sich auch an der Verglasungsinnenraumfläche die Möglichkeit der Kontaktierung über einen elektrischen Kontaktstift. Dieser wird beispielsweise an der Verglasungsinnenraumfläche in den polymeren Grundkörper eingepresst und ragt bis in die elektrische Zuleitung hinein. Bei Einbringen des Kontaktstiftes wird gleichzeitig die Austrittsöffnung geschaffen. Der Kontaktstift bietet dabei die Verlängerung der elektrischen Zuleitung bis in den Verglasungsinnenraum. Das im Verglasungsinnenraum befindliche Ende des Kontaktstiftes kann durch dem Fachmann bekannte Maßnahmen, wie beispielsweise Löten oder Schweißen, an eine elektrische Zuleitung angebunden werden, die wiederum zur Kontaktierung eines elektrischen Verbrauchers im Scheibenzwischenraum dient.

In einer besonders bevorzugten Ausführungsform ist der Abstandhalter ein Doppelabstandhalter, der mindestens eine zusätzliche Scheibe in einer Nut aufnehmen kann. Diese werden beispielsweise für Dreifachverglasungen verwendet, bei denen die dritte Scheibe in einer Nut zwischen der ersten Scheibe und der zweiten Scheibe eingesetzt wird. Derartige Abstandhalter sind unter anderem aus WO 2014/198431 A1 bekannt.

Der Doppelabstandhalter umfasst einen Grundkörper mit erster Scheibenkontaktfläche und einer parallel dazu verlaufenden zweiten Scheibenkontaktfläche, eine Verglasungsinnenraumfläche und eine Außenfläche. Der Grundaufbau entspricht dem beschriebenen Abstandhalter für Doppelverglasungen. Die Verglasungsinnenraumfläche wird durch die Nut in zwei Teilbereiche unterteilt. In den Grundkörper sind eine erste Hohlkammer und eine zweite Hohlkammer eingebracht, die durch die Nut voneinander getrennt sind. Die erste Hohlkammer grenzt an einen ersten Teilbereich der Verglasungsinnenraumfläche, während die zweite Hohlkammer an einen zweiten Teilbereich der Verglasungsinnenraumfläche angrenzt, wobei die Verglasungsinnenraumfläche sich oberhalb der Hohlkammern befinden und die Außenfläche sich unterhalb der Hohlkammern befindet. Oberhalb ist in diesem Zusammenhang als dem Scheibeninnenraum einer Isolierverglasung mit erfindungsgemäßem Abstandshalter zugewandt und unterhalb als dem Scheibeninnenraum abgewandt definiert. Da die Nut zwischen der ersten Verglasungsinnenraumfläche und zweiten Verglasungsinnenraumfläche verläuft, begrenzt sie diese seitlich und trennt die erste Hohlkammer und die zweite Hohlkammer voneinander.

Die Seitenflanken der Nut werden dabei von den Wänden der ersten Hohlkammer und der zweiten Hohlkammer gebildet. Die Nut bildet dabei eine Vertiefung, die geeignet ist die mittlere Scheibe (dritte Scheibe) einer Isolierverglasung aufzunehmen. Dadurch wird die Position der dritten Scheibe über zwei Seitenflanken der Nut sowie die Bodenfläche der Nut fixiert. Eine erste und eine zweite Scheibe können an der ersten und zweiten Scheibenkontaktfläche des Abstandhalters angebracht werden.

Die Führung der elektrischen Zuleitungen innerhalb der Hohlkammern eines Doppelabstandhalters sowie deren Ausführungsdetails sind analog zu den bereits beschriebenen Details des Abstandhalters mit einer einzelnen Hohlkammer. Im Falle eines Abstandhalters für Dreifach- oder Mehrfachisolierverglasungen besteht jedoch eine zusätzliche Möglichkeit zur Positionierung einer Austrittsöffnung der elektrischen Zuleitung. Die Austrittsöffnung kann nicht nur an einer der Scheibenkontaktflächen und/oder an der Verglasungsinnenraumfläche angeordnet werden, sondern kann auch innerhalb der Nut liegen. Ein Abstandhalter mit mehreren Hohlkammern ist auch vorteilhaft im Hinblick darauf, dass elektrische Zuleitungen mit verschiedenen Spannungspotentialen getrennt voneinander in jeweils einer Hohlkammer geführt werden können.

Optional umfasst die Nut eines erfindungsgemäßen Doppelabstandhalters eine Einlage. Die Einlage verhindert ein Verrutschen der Scheibe und eine dadurch bedingte Geräuschentwicklung beim Öffnen und Schließen des Fensters. Die Einlage kompensiert des Weiteren die thermische Ausdehnung der dritten Scheibe bei Erwärmung, so dass unabhängig von den klimatischen Bedingungen eine spannungsfreie Fixierung gewährleistet ist. Die Einlage kann im Bereich der elektrischen Kontaktierung ausgespart sein um den für die Kontaktierung benötigten Platz zur Verfügung zu stellen.

In einer besonders bevorzugten Ausführungsform der Erfindung ist der Abstandhalter ein Abstandhalter für Dreifachverglasungen umfassend mindestens eine Nut zur Aufnahme einer dritten Scheibe, wobei die Austrittsöffnung der Zuleitungen in die Nut mündet. Dies ist vorteilhaft, da die Austrittsöffnung im Einbauzustand des Abstandhalters für den Betrachter nicht sichtbar ist und gleichzeitig die Verklebung des Abstandhalters mit den benachbarten Scheiben nicht beeinflusst.

Bevorzugt ist die Austrittsöffnung in mindestens einer der Seitenflanken der Nut vorgesehen. Eine aus der Austrittsöffnung austretende elektrische Zuleitung befindet sich demnach in direkter Nachbarschaft zur Scheibenoberfläche einer in die Nut eingesetzten Scheibe. Ein auf dieser Scheibe befindliches elektrisch schaltbares Funktionselement kann somit innerhalb der Nut elektrisch leitend mit der elektrischen Zuleitung kontaktiert werden. Der Anschluss des elektrisch schaltbaren Funktionselementes an eine Spannungsversorgung erfolgt demnach im für den Betrachter nicht sichtbaren Bereich.

In sämtlichen beschriebenen Ausführungsformen des erfindungsgemäßen Abstandhalters ist ein Trockenmittel in die mindestens eine Hohlkammer eingebracht, so dass in der Isolierverglasung eventuell vorhandene Restfeuchte durch das Trockenmittel gebunden wird.

Bevorzugt weist die Verglasungsinnenraumfläche des Abstandhalters mindestens eine Öffnung auf. Bevorzugt sind mehrere Öffnungen in der Verglasungsinnenraumfläche angebracht. Die Gesamtzahl der Öffnungen hängt dabei von der Größe der Isolierverglasung ab. Die Öffnungen verbinden die Hohlkammer mit dem inneren Scheibenzwischenraum, wodurch ein Gasaustausch zwischen diesen möglich wird. Dadurch wird eine Aufnahme von Luftfeuchtigkeit durch das in der Hohlkammer befindliche Trockenmittel erlaubt und somit ein Beschlagen der Scheiben verhindert. Die Öffnungen sind bevorzugt als Schlitze ausgeführt, besonders bevorzugt als Schlitze mit einer Breite von 0,2 mm und einer Länge von 2 mm. Die Schlitze gewährleisten einen optimalen Luftaustausch ohne dass Trockenmittel aus der Hohlkammer in den inneren Scheibenzwischenraum eindringen kann.

Sofern der erfindungsgemäße Abstandhalter einen polymeren Grundkörper aufweist, können weitere Maßnahmen zur Verbesserung der Gasdichtigkeit des Grundkörpers vorgesehen sein. Bevorzugt ist mindestens auf der Außenfläche des polymeren Grundkörpers, bevorzugt auf der Außenfläche und auf einem Teil der Scheibenkontaktflächen, eine gas- und dampfdichte Barriere aufgebracht ist. Die gas- und dampfdichte Barriere verbessert die Dichtigkeit des Abstandhalters gegen Gasverlust und Eindringen von Feuchtigkeit. Bevorzugt ist die Barriere auf etwa der Hälfte bis zwei Drittel der Scheibenkontaktflächen aufgebracht. Ein geeigneter Abstandhalter mit polymerem Grundkörper ist beispielsweise in WO 2013/104507 A1 offenbart.

In einer bevorzugten Ausführungsform ist die gas- und dampfdichte Barriere auf der Außenfläche eines polymeren Abstandhalters als Folie ausgeführt. Diese Barrierefolie enthält mindestens eine polymere Schicht sowie eine metallische Schicht oder eine keramische Schicht. Dabei beträgt die Schichtdicke der polymeren Schicht zwischen 5 µm und 80 µm, während metallische Schichten und/oder keramische Schichten mit einer Dicke von 10 nm bis 200 nm eingesetzt werden. Innerhalb der genannten Schichtdicken wird eine besonders gute Dichtigkeit der Barrierefolie erreicht. Die Barrierefolie kann auf dem polymeren Grundkörper aufgebracht werden, beispielsweise geklebt werden. Alternativ kann die Folie mit dem Grundkörper zusammen co-extrudiert werden.

Besonders bevorzugt enthält die Barrierefolie mindestens zwei metallische Schichten und/oder keramische Schichten, die alternierend mit mindestens einer polymeren Schicht angeordnet sind. Die Schichtdicken der einzelnen Schichten sind bevorzugt wie im vorhergehenden Absatz beschrieben. Bevorzugt werden die außenliegenden Schichten dabei von der polymeren Schicht gebildet. In dieser Anordnung sind die metallischen Schichten besonders gut vor Beschädigung geschützt. Die alternierenden Schichten der Barrierefolie können auf die verschiedensten nach dem Stand der Technik bekannten Methoden verbunden bzw. aufeinander aufgetragen werden. Methoden zur Abscheidung metallischer oder keramischer Schichten sind dem Fachmann hinlänglich bekannt. Die Verwendung einer Barrierefolie mit alternierender Schichtenabfolge ist besonders vorteilhaft im Hinblick auf die Dichtigkeit des Systems. Ein Fehler in einer der Schichten führt dabei nicht zu einem Funktionsverlust der Barrierefolie. Im Vergleich dazu kann bei einer Einzelschicht bereits ein kleiner Defekt zu einem vollständigen Versagen führen. Des Weiteren ist die Auftragung mehrerer dünner Schichten im Vergleich zu einer dicken Schicht vorteilhaft, da mit steigender Schichtdicke die Gefahr interner Haftungsprobleme ansteigt. Ferner verfügen dickere Schichten über eine höhere Leitfähigkeit, so dass eine derartige Folie thermodynamisch weniger geeignet ist.

Die polymere Schicht der Folie umfasst bevorzugt Polyethylenterephthalat, Ethylenvinylalkohol, Polyvinylidenchlorid, Polyamide, Polyethylen, Polypropylen, Silikone, Acrylonitrile, Polyacrylate, Polymethylacrylate und/oder Copolymere oder Gemische davon. Die metallische Schicht enthält bevorzugt Eisen, Aluminium, Silber, Kupfer, Gold, Chrom und/oder Legierungen oder Oxide davon. Die keramische Schicht der Folie enthält bevorzugt Siliziumoxide und/oder Siliziumnitride.

In einer alternativen bevorzugten Ausführungsform ist die gas- und dampfdichte Barriere bevorzugt als Beschichtung ausgeführt. Die Beschichtung enthält Aluminium, Aluminiumoxide und / oder Siliciumoxide und wird bevorzugt über ein PVD-Verfahren (physikalische Gasphasenabscheidung) aufgebracht. Dadurch kann das Herstellungsverfahren erheblich vereinfacht werden, da der polymere Grundkörper direkt nach der Herstellung, zum Beispiel durch Extrusion, mit der Barrierebeschichtung versehen wird und kein gesonderter Schritt zum Aufbringen einer Folie nötig ist. Die Beschichtung mit den genannten Materialien liefert besonders gute Ergebnisse im Hinblick auf Dichtigkeit und zeigt zusätzlich exzellente Haftungseigenschaften zu den in Isolierverglasungen verwendeten Materialien der äußeren Versiegelung.

In einer besonders bevorzugten Ausführungsform weist die gas- und dampfdichte Barriere mindestens eine metallische Schicht oder keramische Schicht auf, die als Beschichtung ausgeführt ist und Aluminium, Aluminiumoxide und / oder Siliciumoxide enthält und bevorzugt über ein PVD-Verfahren (physikalische Gasphasenabscheidung) aufgebracht ist.

Der polymere Grundkörper enthält bevorzugt Polyethylen (PE), Polycarbonate (PC), Polypropylen (PP), Polystyrol, Polybutadien, Polynitrile, Polyester, Polyurethane, Polymethylmetacrylate, Polyacrylate, Polyamide, Polyethylenterephthalat (PET), Polybutylenterephthalat (PBT), bevorzugt Acrylnitril-Butadien-Styrol (ABS), Acrylester-Styrol-Acrylnitril (ASA), Acrylnitril-Butadien-Styrol/Polycarbonat (ABS/PC), Styrol-Acrylnitril (SAN), PET/PC, PBT/PC und/oder Copolymere oder Gemische davon. Mit diesen Materialien werden besonders gute Ergebnisse erzielt.

Bevorzugt ist der polymere Grundkörper glasfaserverstärkt. Durch die Wahl des Glasfaseranteils im Grundkörper kann der Wärmeausdehnungskoeffizient des Grundkörpers variiert und angepasst werden. Durch Anpassung des Wärmeausdehnungskoeffizienten des polymeren Grundkörpers und der Barrierefolie oder -beschichtung lassen sich temperaturbedingte Spannungen zwischen den unterschiedlichen Materialien und ein Abplatzen der Barrierefolie oder -beschichtung vermeiden. Der Grundkörper weist bevorzugt einen Glasfaseranteil von 20 % bis 50 %, besonders bevorzugt von 30 % bis 40 % auf. Der Glasfaseranteil im polymeren Grundkörper verbessert gleichzeitig die Festigkeit und Stabilität.

In einer weiteren bevorzugten Ausführungsform ist der polymere Grundkörper gefüllt durch Glashohlkugeln oder Glasblasen. Diese Glashohlkugeln haben einen Durchmesser von 10 µm bis 20 µm und verbessern die Stabilität des polymeren Hohlprofils. Geeignete Glaskugeln sind unter dem Namen "3M^{™} Glass Bubbles" käuflich erhältlich. Besonders bevorzugt enthält der polymere Grundkörper Polymere, Glasfasern und Glaskugeln. Eine Beimischung von Glaskugeln führt zu einer Verbesserung der thermischen Eigenschaften des Hohlprofils.

Der Abstandshalter weist bevorzugt entlang der Scheibenkontaktflächen eine Höhe von 5 mm bis 15 mm, besonders bevorzugt von 5 mm bis 10 mm, auf.

Die Breite der Verglasungsinnenraumfläche, beziehungsweise die Breite der Teilbereiche der Verglasungsinnenraumfläche, die den Abstand zweier benachbarter Scheiben der Isolierverglasung definiert, beträgt 4 mm bis 30 mm, bevorzugt 8 mm bis 16 mm.

Die Erfindung umfasst des Weiteren eine Isolierverglasung mit erfindungsgemäßem Abstandhalter. Die Isolierverglasung umfassend mindestens eine erste Scheibe, eine zweite Scheibe und einen die Scheiben umfassenden umlaufenden erfindungsgemäßen Abstandhalter mit integrierter elektrischer Zuleitung.

An die Verglasungsinnenraumfläche des Abstandhalters angrenzend befindet sich der Verglasungsinnenraum der Isolierverglasung. Die Außenfläche des Abstandhalters grenzt hingegen an den äußeren Scheibenzwischenraum. Die erste Scheibe ist dabei an der ersten Scheibenkontaktfläche des Abstandhalters und die zweite Scheibe an der zweiten Scheibenkontaktfläche des Abstandhalters angebracht.

Die im Abstandhalter der Isolierverglasung integrierte elektrische Zuleitung tritt aus dem äußeren Scheibenzwischenraum in die Hohlkammer des Abstandhalters ein und erstreckt sich innerhalb der Hohlkammer mindestens bis zu einer Position im Randverbund der Isolierverglasung, an der eine elektrische Kontaktierung gewünscht ist. Im Verglasungsinnenraum der Isolierverglasung befindet sich ein elektrisch schaltbares Funktionselement, dessen Spannungsversorgung über die elektrische Zuleitung gewährleistet werden soll. Dazu tritt die elektrische Zuleitung an der gewünschten Stelle der Kontaktierung durch eine Austrittsöffnung in der Wandung des Grundkörpers in den Verglasungsinnenraum zwischen erster Scheibe, zweiter Scheibe und Abstandhalter ein. Die elektrische Zuleitung kontaktiert das elektrisch schaltbare Funktionselement im Verglasungsinnenraum elektrisch leitend.

Die erste und die zweite Scheibe sind an den Scheibenkontaktflächen bevorzugt über ein Dichtmittel angebracht, das zwischen der ersten Scheibenkontaktfläche und der ersten Scheibe und/oder der zweiten Scheibenkontaktfläche und der zweiten Scheibe angebracht ist.

Das Dichtmittel enthält bevorzugt Butylkautschuk, Polyisobutylen, Polyethylenvinylalkohol, Ethylenvinylacetat, Polyolefin-Kautschuk, Polypropylen, Polyethylen, Copolymere und/oder Gemische davon.

Das Dichtmittel ist bevorzugt in mit einer Dicke von 0,1 mm bis 0,8 mm, besonders bevorzugt 0,2 mm bis 0,4 mm in den Spalt zwischen Abstandhalter und Scheiben eingebracht.

Der äußere Scheibenzwischenraum der Isolierverglasung ist bevorzugt mit einer äußeren Abdichtung verfüllt. Diese äußere Abdichtung dient vor allem der Verklebung der beiden Scheiben und somit der mechanischen Stabilität der Isolierverglasung.

Die äußere Abdichtung enthält bevorzugt Polysulfide, Silikone, Silikonkautschuk, Polyurethane, Polyacrylate, Copolymere und/oder Gemische davon. Derartige Stoffe haben eine sehr gute Haftung auf Glas, so dass die äußere Abdichtung eine sichere Verklebung der Scheiben gewährleistet. Die Dicke der äußeren Abdichtung beträgt bevorzugt 2 mm bis 30 mm, besonders bevorzugt 5 mm bis 10 mm.

Die Isolierverglasung kann auch mehrere elektrische Zuleitungen enthalten, die den Grundkörper des Abstandhalters parallel zueinander oder auch in unterschiedlichen Abschnitten des Abstandhalters durchlaufen. Bevorzugt werden alle elektrischen Zuleitungen an der gleichen Stelle vom äußeren Scheibenzwischenraum ausgehend in die Hohlkammer des Abstandhalters eingeführt. Dies ist vorteilhaft, da so nur eine einzelne Eintrittsöffnung besteht und die Gefahr von Undichtigkeiten im Randverbund dadurch minimiert wird.

Je nach Ausgestaltung des elektrisch schaltbaren Funktionselements können mehrere elektrische Zuleitungen unterschiedlicher Polarität bestehen, die an verschiedenen Positionen des elektrisch schaltbaren Funktionselements mit diesem kontaktiert werden.

Das eigentliche Funktionselement mit elektrisch schaltbaren optischen Eigenschaften wird mindestens durch zwei elektrisch leitfähige Schichten und eine aktive Schicht gebildet. Die elektrisch leitfähigen Schichten bilden dabei Flächenelektroden. Durch Anlegen einer Spannung an die Flächenelektroden, beziehungsweise durch Änderung der an den Flächenelektroden anliegenden Spannung können die optischen Eigenschaften der aktiven Schicht, insbesondere die Transmission und/oder die Streuung von sichtbarem Licht beeinflusst werden.

Die elektrisch leitfähigen Schichten sind bevorzugt transparent. Die elektrisch leitfähigen Schichten enthalten bevorzugt zumindest ein Metall, eine Metalllegierung oder ein transparentes leitfähiges Oxid *(transparent conducting oxide,* TCO). Die elektrisch leitfähigen Schichten enthalten bevorzugt zumindest ein transparentes leitfähiges Oxid.

Die elektrisch leitfähigen Schichten weisen bevorzugt eine Dicke von 10 nm bis 2 µm auf, besonders bevorzugt von 20 nm bis 1 µm, ganz besonders bevorzugt von 30 nm bis 500 nm und insbesondere von 50 nm bis 200 nm. Damit wird eine vorteilhafte elektrische Kontaktierung der aktiven Schicht erreicht.

Die elektrisch leitfähigen Schichten sind dafür vorgesehen, mit zumindest einer externen Spannungsquelle elektrisch leitend verbunden zu werden, um als Flächenelektroden des schaltbaren Funktionselements zu dienen.

Das eigentliche schaltbare Funktionselement kann prinzipiell jedes dem Fachmann an sich bekannte Funktionselement mit elektrisch schaltbaren optischen Eigenschaften sein. Die Ausgestaltung der aktiven Schicht richtet sich nach der Art des Funktionselements.

In einer vorteilhaften Ausgestaltung der Erfindung ist im inneren Scheibenzwischenraum ein elektrochromes Funktionselement enthalten. Dabei ist die aktive Schicht der Mehrschichtfolie eine elektrochemisch aktive Schicht. Die Transmission von sichtbarem Licht ist vom Einlagerungsgrad von Ionen in die aktive Schicht abhängig, wobei die Ionen beispielsweise durch eine lonenspeicherschicht zwischen aktiver Schicht und einer Flächenelektrode bereitgestellt werden. Die Transmission kann durch die an die Flächenelektroden angelegte Spannung, welche eine Wanderung der Ionen hervorruft, beeinflusst werden. Geeignete aktive Schichten enthalten beispielsweise zumindest Wolframoxid oder Vanadiumoxid. Elektrochrome Funktionselemente sind beispielsweise aus WO 2012007334 A1, US 20120026573 A1, WO 2010147494 A1 und EP 1862849 A1 bekannt.

In einer weiteren vorteilhaften Ausgestaltung der Erfindung ist im inneren Scheibenzwischenraum ein PDLC-Funktionselement (Polymer dispersed liquid crystal) angebracht. Dabei enthält die aktive Schicht Flüssigkristalle, welche beispielsweise in eine Polymermatrix eingelagert sind. Wird an die Flächenelektroden keine Spannung angelegt, so sind die Flüssigkristalle ungeordnet ausgerichtet, was zu einer starken Streuung des durch die aktive Schicht tretenden Lichts führt. Wird an die Flächenelektroden eine Spannung angelegt, so richten sich die Flüssigkristalle in einer gemeinsamen Richtung aus und die Transmission von Licht durch die aktive Schicht wird erhöht. Ein solches Funktionselement ist beispielsweise aus DE 102008026339 A1 bekannt.

In einer weiteren vorteilhaften Ausgestaltung der Erfindung umfasst die Isolierverglasung im inneren Scheibenzwischenraum ein elektrolumineszentes Funktionselement. Dabei enthält die aktive Schicht elektrolumineszente Materialen, welche anorganisch oder organisch (OLED) sein können. Durch Anlegen einer Spannung an die Flächenelektroden wird die Lumineszenz der aktiven Schicht angeregt. Solche Funktionselemente sind beispielsweise aus US 2004227462 A1 und WO 2010112789 A2 bekannt.

In einer weiteren vorteilhaften Ausgestaltung der Erfindung ist das elektrisch schaltbare Funktionselement ein SPD-Funktionselement (suspended particle device). Dabei enthält die aktive Schicht suspendierte Partikel, welche bevorzugt in eine zähflüssige Matrix eingelagert sind. Die Absorption von Licht durch die aktive Schicht ist durch das Anlegen einer Spannung an die Flächenelektroden veränderbar, welche zu einer Orientierungsänderung der suspendierten Partikel führt. Solche Funktionselemente sind beispielsweise aus EP 0876608 B1 und WO 2011033313 A1 bekannt.

Das elektrisch schaltbare Funktionselement kann natürlich außer der aktiven Schicht und den elektrisch leitfähigen Schichten weitere an sich bekannte Schichten aufweisen, beispielsweise Barriereschichten, Blockerschichten, Antireflexions- oder Reflexionsschichten, Schutzschichten und/oder Glättungsschichten.

Das elektrisch schaltbare Funktionselement kann alternativ auch eine elektrisch beheizbare Beschichtung, eine in der Isolierverglasung integrierte photovoltaische Beschichtung und/oder ein dünnschichttransistorbasiertes Flüssigkristalldisplay (TFT-basiertes LCD) umfassen.

Das elektrisch schaltbare Funktionselement kann an beliebiger Stelle innerhalb des inneren Scheibenzwischenraums angeordnet sein. Bevorzugt befindet sich das elektrisch schaltbare Funktionselement auf einer der im inneren Scheibenzwischenraum befindlichen Oberflächen der Scheiben der Isolierverglasung.

Bei einer Doppelisolierverglasung ist das elektrisch schaltbare Funktionselement bevorzugt auf der zum inneren Scheibenzwischenraum gerichteten Oberfläche der ersten Scheibe und/oder der zweiten Scheibe angebracht.

Besonders bevorzugt handelt es sich bei der erfindungsgemäßen Isolierverglasung um eine Dreifach- oder Mehrfachisolierverglasung. In diesem Fall ist das elektrisch schaltbare Funktionselement bevorzugt auf der dritten Scheibe oder darüberhinausgehenden weiteren Scheiben, die zwischen der ersten Scheibe und der zweiten Scheibe angeordnet sind, aufgebracht.

In einer besonders bevorzugten Ausführungsform der Erfindung umfasst die Isolierverglasung mindestens drei Scheiben und einen Doppelabstandhalter mit Nut, in dessen Nut die dritte Scheibe eingesetzt ist. Die erste und die zweite Scheibe liegen an den Scheibenkontaktflächen an. Das elektrisch schaltbare Funktionselement ist in diesem Fall auf einer der Oberflächen der dritten Scheibe aufgebracht. Die elektrische Kontaktierung zwischen Zuleitung und elektrisch schaltbarem Funktionselement erfolgt dabei in besonders vorteilhafter Weise innerhalb der Nut. Die elektrische Zuleitung wird aus der Hohlkammer heraus durch eine Austrittsöffnung in der Wandung der Nut geführt und innerhalb der Nut zum elektrisch schaltbaren Funktionselement geführt. Die elektrische Kontaktierung des Funktionselements befindet sich somit vollständig innerhalb der Nut und ist für den Betrachter nach Montage der Isolierverglasung nicht sichtbar.

Die elektrische Verbindung der Zuleitung und der elektrisch leitfähigen Schichten des Funktionselements erfolgt bevorzugt über sogenannte Sammelleiter, beispielsweise Streifen eines elektrisch leitfähigen Materials oder elektrisch leitfähige Aufdrucke, mit denen die elektrisch leitfähigen Schichten verbunden werden. Die Sammelleiter, auch als bus bars bezeichnet, dienen der Übertragung elektrischer Leistung und ermöglichen eine homogene Spannungsverteilung. Die Sammelleiter werden vorteilhaft durch Aufdrucken einer leitfähigen Paste hergestellt. Die leitfähige Paste enthält bevorzugt Silber-Partikel und Glasfritten. Die Schichtdicke der leitfähigen Paste beträgt bevorzugt von 5 µm bis 20 µm.

In einer alternativen Ausgestaltung werden dünne und schmale Metallfolienstreifen oder Metalldrähte als Sammelleiter verwendet, die bevorzugt Kupfer und / oder Aluminium enthalten, insbesondere werden Kupferfolienstreifen mit einer Dicke von beispielsweise etwa 50 µm verwendet. Die Breite der Kupferfolienstreifen beträgt bevorzugt 1 mm bis 10 mm. Der elektrische Kontakt zwischen einer als Flächenelektrode dienenden elektrisch leitfähigen Schicht des Funktionselements und dem Sammelleiter kann beispielsweise durch Auflöten oder Kleben mit einem elektrisch leitfähigen Kleber hergestellt werden.

In einer vorteilhaften Ausführungsform der Erfindung ist eine dritte Scheibe mit elektrisch schaltbarem Funktionselement in die Nut eines Doppelabstandhalters eingesetzt, wobei ein Sammelleiter entlang der Scheibenkante der dritten Scheibe aufgedruckt ist. Der Sammelleiter ist dabei so bemessen, dass dieser nach Einsetzen der Scheibe in die Nut des Abstandhalters vollständig von der Nut verdeckt wird. Demnach ergibt sich die Höhe des Sammelleiters, gemessen senkrecht zur nächstliegenden Scheibenkante, aus der Höhe der Nut des Abstandhalters abzüglich des Abstandes von Sammelleiter und nächstliegender Scheibenkante. Bevorzugt weist die Nut eine Höhe von 3 mm bis 10 mm, besonders bevorzugt 3 mm bis 6 mm, beispielsweise 5 mm auf, und die Höhe des Sammelleiters beträgt 2 mm bis 9 mm, bevorzugt 2 mm bis 5 mm. Der Abstand des Sammelleiters zur nächstliegenden Scheibenkante beträgt beispielsweise 1 mm.

Auch unter Verwendung von Sammelleitern ist somit eine für den Betrachter unsichtbare Kontaktierung innerhalb der Nut möglich. Alternativ kann der Sammelleiter weiterhin im sichtbaren Bereich der Scheibe liegen und dabei beliebig weit von der nächstliegenden Scheibenkante entfernt sein. Optional kann der Sammelleiter dabei von dekorativen Elementen, beispielsweise einem Siebdruck verdeckt sein.

Erfindungsgemäß besitzt der Doppelabstandhalter mit Nut einen polymeren Grundkörper, wodurch ein Kurzschluss zwischen stromführenden Bauteilen innerhalb der Nut des Abstandhalters und einem metallischen Grundkörper des Abstandhalters vermieden wird.

Die elektrische Kontaktierung zwischen elektrischer Zuleitung und Sammelleiter kann sowohl mittelbar über Kontaktelemente als auch unmittelbar erfolgen. Kontaktelemente werden verwendet um eine möglichst gute Anbindung an den Sammelleiter im Hinblick auf mechanische Stabilität der Verbindung und Minimierung eines unerwünschten Spannungsabfalls zu erzielen. Dem Fachmann sind geeignete Mittel bekannt um das Kontaktelement beispielsweise durch Löten oder Kleben mittels eines leitfähigen Klebstoffs elektrisch leitend am Sammelleiter zu fixieren.

Bevorzugt ist das Kontaktelement als Federkontakt ausgeführt. Dies ist besonders vorteilhaft, da auf diese Weise eine reversible Verbindung von Kontaktelement und Sammelleiter besteht und der elektrische Kontakt zwischen Kontaktelement und Sammelleiter bereits unmittelbar durch Einsetzen der den Sammelleiter tragenden Scheibe in die Nut des Abstandhalters zustande kommt.

Die erste Scheibe, die zweite Scheibe und/oder die dritte Scheibe der Isolierverglasung enthalten bevorzugt Glas, besonders bevorzugt Quarzglas, Borosilikatglas, Kalk-Natron-Glas und/oder Gemische davon. Die erste und/oder zweite Scheibe der Isolierverglasung können auch thermoplastische polymere Scheiben umfassen. Thermoplastische polymere Scheiben umfassen bevorzugt Polycarbonat, Polymethylmethacrylat und/oder Copolymere und/oder Gemische davon. Darüberhinausgehende Scheiben der Isolierverglasung können die gleiche Zusammensetzung haben wie für die erste, zweite und dritte Scheibe erwähnt.

Die erste Scheibe und die zweite Scheibe verfügen über eine Dicke von 2 mm bis 50 mm, bevorzugt 2 mm bis 10 mm, besonders bevorzugt 4 mm bis 6 mm, wobei beide Scheiben auch unterschiedliche Dicken haben können.

Die erste Scheibe, die zweite Scheibe und weitere Scheiben können aus Einscheibensicherheitsglas, aus thermisch oder chemisch vorgespanntem Glas, aus Floatglas, aus extraklarem eisenarmem Floatglas, gefärbtem Glas, oder aus Verbundsicherheitsglas enthaltend eine oder mehrere dieser Komponenten ausgeführt sein. Die Scheiben können beliebige weitere Komponenten oder Beschichtungen, beispielsweise Low-E-Schichten oder anderweitige Sonnenschutzbeschichtungen, aufweisen.

Der äußere Scheibenzwischenraum, begrenzt durch erste Scheibe, zweite Scheibe und Außenfläche des Abstandhalters, ist zumindest teilweise, bevorzugt vollständig, mit einer äußeren Versiegelung verfüllt. Dadurch wird eine sehr gute mechanische Stabilisierung des Randverbunds erzielt. Ferner umgibt die Versiegelung den Druckausgleichskörper und schützt diesen auf diese Weise gegenüber mechanischer Einwirkung von außen.

Bevorzugt enthält die äußere Versiegelung Polymere oder silanmodifizierte Polymere, besonders bevorzugt organische Polysulfide, Silikone, raumtemperaturvernetzenden (RTV) Silikonkautschuk, peroxidischvernetzten Silikonkautschuk und/oder additions-vernetzten Silikonkautschuk, Polyurethane und/oder Butylkautschuk.

Das Dichtmittel zwischen der ersten Scheibenkontaktfläche und der ersten Scheibe, beziehungsweise zwischen der zweiten Scheibenkontaktfläche und der zweiten Scheibe, enthält bevorzugt ein Polyisobutylen. Das Polyisobutylen kann ein vernetzendes oder nicht vernetzendes Polyisobutylen sein.

Die Isolierverglasung ist optional mit einem Schutzgas, bevorzugt mit einem Edelgas, vorzugsweise Argon oder Krypton befüllt, die den Wärmeübergangswert im Isolierverglasungszwischenraum reduzieren.

Grundsätzlich sind verschiedenste Geometrien der Isolierverglasung möglich, beispielsweise rechteckige, trapezförmige und abgerundete Formen. Zur Herstellung runder Geometrien kann der Abstandhalter beispielsweise im erwärmten Zustand gebogen werden.

An den Ecken der Isolierverglasung sind die Abstandhalter beispielsweise über Eckverbinder miteinander verknüpft. Derartige Eckverbinder können beispielsweise als Kunststoffformteil mit Dichtung ausgeführt sein, in dem zwei Abstandhalter zusammenstoßen. Eine elektrische Zuleitung kann beispielsweise durch den offenen Querschnitt des Abstandhalters in Nachbarschaft zu einer Ecke aus dem Grundkörper des Abstandhalters herausgeführt werden, entlang des Eckverbinders im äußeren Scheibenzwischenraum geführt werden und durch den offenen Querschnitt eines benachbarten Abstandhalters wieder in dessen Hohlkammer eingeführt werden.

In einer weiteren bevorzugten Ausführungsform wird der Abstandhalter an den Ecken der Verglasung nicht zertrennt und im erforderlichen Winkel über Eckverbinder verbunden, sondern wird unter Erwärmung in die entsprechende Eckgeometrie gebogen. Dies ist vorteilhaft, da sich auf diese Weise eine durchgängige Hohlkammer umlaufend entlang der Kante der Verglasung ergibt. Die elektrischen Zuleitungen können somit auch im Eckbereich ungehindert innerhalb der Hohlkammer geführt werden.

Die Erfindung umfasst ferner ein Verfahren zur Herstellung einer erfindungsgemäßen Isolierverglasung umfassend die Schritte:
a) Bereitstellung eines Abstandhalters mit integrierter elektrischer Zuleitung,
b) Anbringen des Abstandhalters zwischen einer ersten Scheibe und einer zweiten Scheibe über jeweils eine Scheibenkontaktfläche des Abstandhalters mittels eines Dichtmittels und Einbringen eines elektrisch schaltbaren Funktionselements in den Verglasungsinnenraum,
c) Verpressen der Scheibenanordnung,
d) Einbringen einer äußeren Abdichtung in den äußeren Scheibenzwischenraum.

Die elektrische Zuleitung wird in Schritt b) elektrisch leitend mit dem elektrisch schaltbaren Funktionselement kontaktiert. Dazu wird ein Abschnitt der elektrischen Zuleitung über eine Austrittsöffnung aus dem Abstandhalter herausgeführt. Die Austrittsöffnung kann je nach ihrer Positionierung während Schritt b) oder auch vor Schritt b) erzeugt werden. Eine Austrittsöffnung auf den Scheibenkontaktflächen muss vor Anbringen der Scheiben auf diesen Flächen erfolgen. Auch sofern die Austrittsöffnung auf der Verglasungsinnenraumfläche liegt, so wird diese bevorzugt bereits vor Schritt b) erzeugt, da in diesem Stadium die Scheiben nicht hinderlich wirken. Die Öffnung wird bevorzugt in Form einer Bohrung in den Grundkörper des Abstandhalters eingebracht.

Das elektrisch schaltbare Funktionselement wird gleichzeitig mit dem Anbringen der Scheiben in Schritt b) in den Verglasungsinnenraum eingebracht, da dieses in der Regel auf einer der nach Montage im Innenraum der Isolierverglasung liegenden Oberflächen der Scheiben angebracht ist.

Die Verklebung der Scheiben an den Scheibenkontaktflächen gemäß Schritt b) kann in einer beliebigen Reihenfolge durchgeführt werden. Optional kann die Verklebung beider Scheiben an den Scheibenkontaktflächen auch gleichzeitig erfolgen.

In Schritt d) wird der äußere Scheibenzwischenraum zumindest teilweise, bevorzugt vollständig, mit einer äußeren Abdichtung verfüllt. Die äußere Abdichtung wird bevorzugt direkt in den äußeren Scheibenzwischenraum hinein extrudiert, beispielsweise in Form einer plastischen Abdichtmasse.

Bevorzugt wird der Verglasungsinnenraum zwischen den Scheiben vor dem Verpressen der Anordnung (Schritt c)) mit einem Schutzgas gefüllt.

Bevorzugt wird vor Schritt b) ein Trockenmittel über den offenen Querschnitt des Abstandhalters in die Hohlkammer eingefüllt.

Handelt es sich bei der herzustellenden Verglasung um eine Mehrfachverglasung mit Doppelabstandhalter umfassend mindestens eine Nut, so wird mindestens eine dritte Scheibe vor Schritt b) in die Nut des Abstandhalters eingesetzt.

Die Erfindung umfasst des Weiteren die Verwendung eines erfindungsgemäßen Abstandhalters in Isolierverglasungen umfassend elektrisch schaltbare Funktionselemente, besonders bevorzugt in Doppel- oder Dreifachisolierverglasungen, insbesondere in Doppel- oder Dreifachisolierverglasungen umfassend ein SPD-, ein PDLC-, ein elektrochromes oder ein elektrolumineszentes Funktionselement. In sämtlichen dieser Verglasungen mit elektrisch schaltbaren Komponenten wird eine Stromversorgung im Verglasungsinnenraum benötigt, so dass eine elektrische Zuleitung vom äußeren Scheibenzwischenraum in den Verglasungsinnenraum geführt werden muss, was durch die Verwendung des erfindungsgemäßen Abstandhalters wesentlich verbessert wird.

Im Folgenden wird die Erfindung anhand von Zeichnungen näher erläutert. Die Zeichnungen sind rein schematische Darstellungen und nicht maßstabsgetreu. Sie schränken die Erfindung in keiner Weise ein. Es zeigen:
Figuren 1a und 1b schematische Darstellungen des Abstandhalters im Querschnitt, wobei Figur 1a einen nicht-erfindungsgemäßen Abstandhalter zeigt und Figur 1b einen erfindungsgemäßen Abstandhalter zeigt.
Figur 2a eine schematische Darstellung der Isolierverglasung mit einem Abstandhalter gemäß Figur 1b im Querschnitt,
Figur 2b die Isolierverglasung gemäß Figur 2a in Gesamtansicht,
Figur 3 eine Ausführungsform einer nicht-erfindungsgemäßen Dreifachisolierverglasung mit Doppelabstandhalter im Querschnitt,
Figur 4 ein Flussdiagramm einer möglichen Ausführungsform des erfindungsgemäßen Verfahrens.

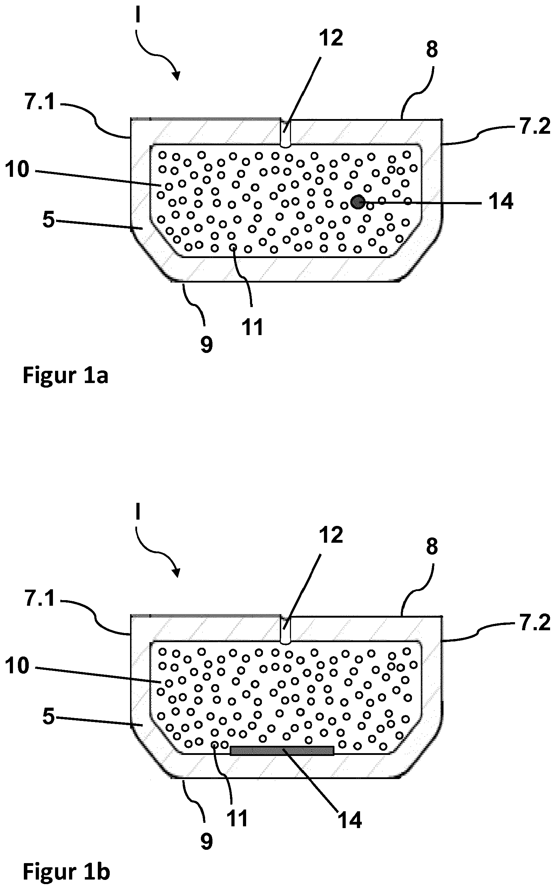

Die Ausführungsformen der Abbildungen 1a, 2a, 2b und 3 zeigen Abstandhalter, bei denen die Zuleitung nicht stoffschlüssig an der Innenwandung angebunden ist. Daher sind diese Ausführungsformen nicht erfindungsgemäß. Sie helfen jedoch, weitere Aspekte der Erfindung zu verstehen.

Figur 1a zeigt eine schematische Darstellung eines nicht-erfindungsgemäßen Abstandhalters I umfassend einen polymeren Grundkörper 5 und eine elektrische Zuleitung 14 innerhalb des Grundkörpers 5. Der polymere Grundkörper 5 ist ein Hohlkörperprofil umfassend zwei Scheibenkontaktflächen 7.1 und 7.2, eine Verglasungsinnenraumfläche 8, eine Außenfläche 9 und eine Hohlkammer 10. Der polymere Grundkörper 5 enthält Styrol-Acryl-Nitryl (SAN) und etwa 35 Gew.-% Glasfaser. Die Außenfläche 9 besitzt eine abgewinkelte Form, wobei die den Scheibenkontaktflächen 7.1 und 7.2 benachbarten Abschnitte der Außenfläche in einem Winkel von 30° zu den Scheibenkontaktflächen 7.1 und 7.2 geneigt sind. Dies verbessert die Stabilität des glasfaserverstärkten polymeren Grundkörpers 5. Der Hohlkörper 10 ist mit einem Trockenmittel 11 gefüllt. Als Trockenmittel 11 wird Molekularsieb eingesetzt. Die Verglasungsinnenraumfläche 8 des Abstandhalters I weist Öffnungen 12 auf, die in regelmäßigen Abständen umlaufend entlang der Verglasungsinnenraumfläche 8 angebracht sind um einen Gasaustausch zwischen dem Innenraum der Isolierverglasung und der Hohlkammer 10 zu ermöglichen. Somit wird eventuell vorhandene Luftfeuchtigkeit im Innenraum vom Trockenmittel 11 aufgenommen. Die Öffnungen 12 sind als Schlitze mit einer Breite von 0,2 mm und einer Länge von 2 mm ausgeführt. Auf der Außenfläche 9 des Abstandhalters I ist eine Barrierefolie (nicht gezeigt) aufgebracht, die den Wärmeübergang durch den polymeren Grundkörper 5 in den Verglasungsinnenraum vermindert. Die Barrierefolie umfasst vier polymere Schichten aus Polyethylenterephthalat mit einer Dicke von 12 µm und drei metallische Schichten aus Aluminium mit einer Dicke von 50 nm. Die metallischen Schichten und die polymeren Schichten sind dabei jeweils alternierend angebracht, wobei die beiden äußeren Lagen von polymeren Schichten gebildet werden. Der polymere Grundkörper 5 ist nichtleitend für den elektrischen Strom, so dass die elektrische Zuleitung 14 über keinerlei elektrische Isolierung verfügt. Die elektrische Zuleitung 14 durchläuft den polymeren Grundkörper 5 auf seiner gesamten Länge, die im Beispiel gemäß Figur 1a einer Länge von 2,0 m entspricht. Die elektrische Zuleitung 14 ragt an beiden offenen Querschnitten aus dem Grundkörper 5 hinaus und weist eine Gesamtlänge von 2,2 m auf.

Figur 1b zeigt eine Ausführungsform eines erfindungsgemäßen Abstandhalters I umfassend einen polymeren Grundkörper 5 und eine elektrische Zuleitung 14 innerhalb des Grundkörpers 5. Der Abstandhalter I der Figur 1b entspricht dem in Figur 1a beschriebenen, wobei im Unterschied dazu die elektrische Zuleitung 14 stoffschlüssig mit der an die Außenfläche 9 grenzenden Innenwandung des polymeren Grundkörpers 5 verbunden ist. Die elektrische Zuleitung 14 ist als metallischer Flachbandleiter ausgeführt, der unmittelbar bei Extrusion des polymeren Grundkörpers 5 in diesen eingelegt wurde und stoffschlüssig mit diesem verbunden ist. In dieser Ausführungsform kann darauf verzichtet werden die elektrische Zuleitung 14 über die Länge des polymeren Grundkörpers 5 hinausragen zu lassen. Die Position der elektrischen Zuleitung 14 ist durch die stoffschlüssige Anbindung definiert und fixiert, so dass eine elektrische Kontaktierung nicht über ein hinausragendes Ende der Zuleitung erfolgen muss, sondern die elektrische Zuleitung 14 beispielsweise durch einen Kontaktstift ergänzt werden kann, der durch die Außenfläche 9 und den polymeren Grundkörper 5 in den Leiter eingedrückt wird. Der Kontaktstift schafft dabei eine Eintrittsöffnung und bildet die Verlängerung der Zuleitung in den äußeren Scheibenzwischenraum.

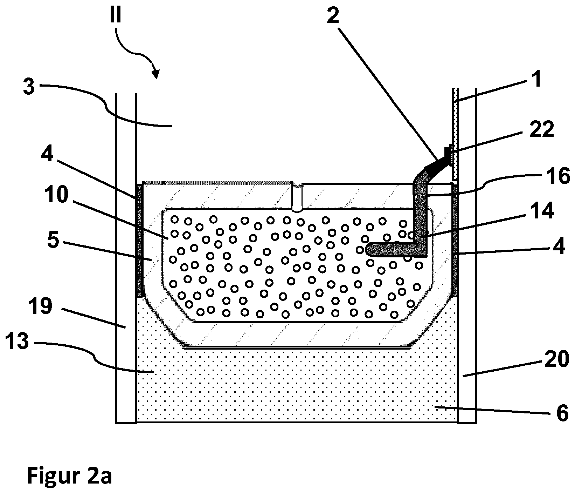

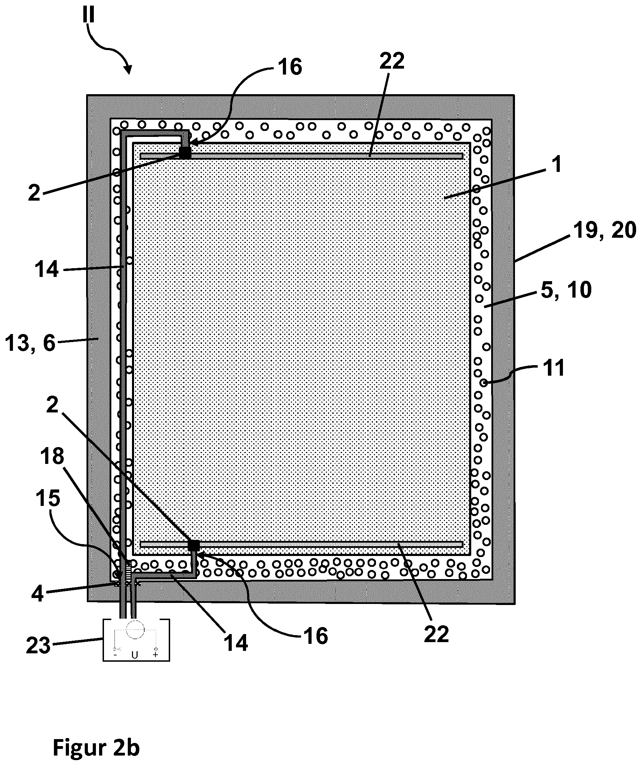

Figur 2a zeigt eine nicht-erfindungsgemäße Isolierverglasung II mit einem Abstandhalter I gemäß Figur 1a. Zwischen einer ersten Scheibe 19 und einer zweiten Scheibe 20 ist über ein Dichtmittel 4 umlaufend der Abstandhalter I angebracht. Das Dichtmittel 4 verbindet dabei die Scheibenkontaktflächen 7.1 und 7.2 des Abstandhalters I mit den Scheiben 19 und 20. Der an die Verglasungsinnenraumfläche 8 des Abstandshalters I angrenzende Verglasungsinnenraum 3 wird als der von den Scheiben 19, 20 und dem Abstandhalter I begrenzte Raum definiert. Der an die Außenfläche 9 des Abstandhalters I angrenzende äußere Scheibenzwischenraum 13 ist ein streifenförmiger umlaufender Abschnitt der Verglasung, der von je einer Seite von den beiden Scheiben 19, 20 und auf einer weiteren Seite von dem Abstandhalter I begrenzt wird und dessen vierte Kante offen ist. Der Verglasungsinnenraum 3 ist mit Argon gefüllt. Zwischen jeweils einer Scheibenkontaktfläche 7.1 bzw. 7.2 und der benachbarten Scheibe 19 bzw. 20 ist ein Dichtmittel 4 eingebracht, das den Spalt zwischen Scheibe 19, 20 und Abstandhalter I abdichtet. Das Dichtmittel 4 ist Polyisobutylen. Auf der Außenfläche 9 ist eine äußere Abdichtung 6 im äußeren Scheibenzwischenraum 13 angebracht, die der Verklebung der ersten Scheibe 19 und der zweiten Scheibe 20 dient. Die äußere Abdichtung 6 besteht aus Silikon. Die äußere Abdichtung 6 schließt bündig mit den Scheibenkanten der ersten Scheibe 19 und der zweiten Scheibe 20 ab. Die zweite Scheibe 20 weist an der zum Verglasungsinnenraum 3 gerichteten Scheibenoberfläche ein elektrisch schaltbares Funktionselement 1 auf, das mit einem Sammelleiter 22 zur elektrischen Kontaktierung des Funktionselements 1 ausgestattet ist. Bei dem elektrisch schaltbaren Funktionselement 1 handelt es sich um eine elektrochrome Schicht. In den Abstandhalter I gemäß Figur 1 wurde bei Montage in der Isolierverglasung II eine Austrittsöffnung 16 eingebracht. Diese liegt in Nachbarschaft zum Sammelleiter 22. Die elektrische Zuleitung 14 wird bei Montage durch die Austrittsöffnung 16 in der Verglasungsinnenraumfläche 8 herausgezogen. Die herausgezogene Leitungsschleife der elektrischen Zuleitung 14 wird über ein Kontaktelement 2 mit dem Sammelleiter 22 kontaktiert. Das Kontaktelement 2 ist ein sogenannter Crimpverbinder, wobei die Anbindung zwischen elektrischer Zuleitung 14 und Kontaktelement 2 durch Quetschen der Zuleitung in den Crimpverbinder erfolgt und das entgegengesetzte Ende des Crimpverbinders auf den Sammelleiter 22 gelötet ist. Durch die Leitungsführung der elektrischen Zuleitung 14 in der Hohlkammer 10 ist der äußere Scheibenzwischenraum 13 größtenteils frei von Leitungen, so dass ein ungehindertes automatisiertes Verfüllen mit der äußeren Abdichtung 6 erfolgen kann. Die Isolierverglasung II gemäß Figuren 2a und 2b ist in einer weiteren Ausführungsform besonders bevorzugt mit dem Abstandhalter I gemäß Figur 1b realisiert (hier nicht im Detail gezeigt). Die Anbindung zwischen elektrischer Zuleitung 14 und Kontaktelement 2 erfolgt dabei über einen elektrischen Kontaktstift, der in die Verglasungsinnenraumfläche 8 eingepresst wird und in die elektrische Zuleitung 14 gemäß Figur 1b hineinragt. Im Verglasungsinnenraum 3 ist der Kontaktstift über einen weiteren Abschnitt der elektrischen Zuleitung (nicht gezeigt) am Kontaktelement 2 angebunden.

Figur 2b zeigt eine Gesamtansicht feiner nicht-erfindungsgemäße Isolierverglasung II gemäß Figur 2a. Die in Figur 2a beschriebene Kontaktierung einer im Abstandhalter I verlaufenden elektrischen Zuleitung 14 mit dem Sammelleiter 22 des elektrisch schaltbaren Funktionselements 1 findet an zwei gegenüberliegenden Kanten der Isolierverglasung II statt. An beiden Kanten tritt die elektrische Zuleitung 14, wie in Figur 2a beschrieben, durch eine Austrittsöffnung 16 aus dem Hohlkörper 10 in den Verglasungsinnenraum 3 ein und wird über ein Kontaktelement 2 elektrisch leitend mit dem Sammelleiter 22 kontaktiert. Der Abstandhalter I ist an den Ecken der Isolierverglasung II gebogen, so dass die Hohlkammer 10 auch an den Ecken der Verglasung durchgängig ist. Beide elektrische Zuleitungen 14 werden innerhalb des Grundkörpers 5 bis zu einer gemeinsamen Austrittsöffnung 15 geführt, an der die Zuleitungen 14 aus der Hohlkammer 10 in den äußeren Scheibenzwischenraum 13 eintreten und von dort aus mit einer Spannungsquelle 23, hier einer Gleichspannungsquelle zum Betreib eines elektrochromen Funktionselements, außerhalb der Verglasung verbunden werden. Die Zuleitungen 14 sind mit unterschiedlichen Polen der Spannungsquelle verbunden, so dass zwischen den beiden gegenüberliegenden Sammelleitern 22 eine Potentialdifferenz entsteht. Die an den Sammelleitern 22 anliegende Spannung ruft eine lonenwanderung innerhalb der aktiven Schicht des elektrochromen Funktionselements hervor, wodurch dessen Transmission beeinflusst wird. Die Austrittsöffnung 15 ist mit dem Dichtmittel 4 abgedichtet. Da die elektrischen Zuleitungen 14 unterschiedlicher Polarität im Bereich der Austrittsöffnung 15 in Nachbarschaft zueinander liegen, wird in diesem Bereich eine Isolierung 18 eingebracht, die einen elektrischen Kontakt der beiden Zuleitungen 14 verhindert. Die elektrischen Zuleitungen 14 durchlaufen den Grundkörper 5 entlang seines gesamten Umfangs, da zur Herstellung des Abstandhalterrahmens ein Abstandhalter I verwendet wurde, der bereits mit integrierter elektrischer Zuleitung 14 extrudiert wurde. Der übersichtlichen Darstellung halber werden in Figur 2a nur die Abschnitte der elektrischen Zuleitung 14 gezeigt, die dem Anschluss des elektrochromen Funktionselementes dienen. Die Isolierverglasung II wird bevorzugt so in einem Fensterrahmen montiert, dass die Austtrittsöffnung 15 im oberen Drittel der Isolierverglasung zu liegen kommt um die Gefahr eines Wassereintritts bei Stauwasser zu minimieren.

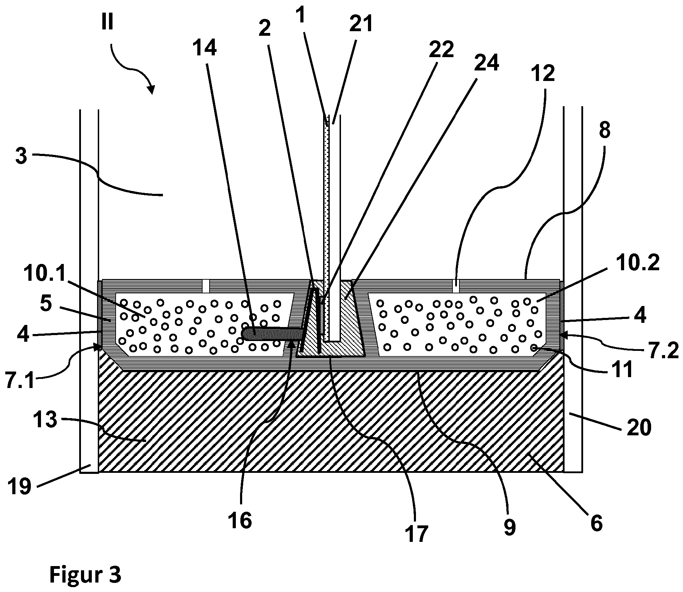

Figur 3 zeigt eine Ausführungsform einer nicht-erfindungsgemäßen Dreifachisolierverglasung mit Doppelabstandhalter im Querschnitt. Der Grundaufbau der Isolierverglasung II entspricht dabei dem in Figur 2a und 2b beschriebenen. Im Unterschied dazu weist der polymere Grundkörper 5 zwischen der ersten Scheibenkontaktfläche 7.1 und der zweiten Scheibenkontaktfläche 7.2 eine Nut 17 auf, wobei zwischen der Nut 17 und der ersten Scheibenkontaktfläche 7.1 eine erste Hohlkammer 10.1 und zwischen der Nut 17 und der zweiten Scheibenkontaktfläche 7.2 eine zweite Hohlkammer 10.2 liegt. Die Seitenflanken der Nut 17 werden dabei von den Wänden der beiden Hohlkammern 10.1 und 10.2 gebildet, während die Bodenfläche der Nut 17 direkt an die Außenfläche 9 grenzt. Die Nut 17 verläuft parallel zu den Scheibenkontaktflächen 7. In die Nut 17 des Abstandhalters I ist eine dritte Scheibe 21 eingesetzt, die auf einer Scheibenoberfläche ein elektrisch schaltbares Funktionselement 1, hier ebenfalls ein elektrochromes Funktionselement, mit einem Sammelleiter 22 trägt. Die Austrittsöffnung 16 befindet sich in einer der Seitenflanken der Nut 17 und mündet in die Nut 17. In der Nut 17 befindet sich ein Kontaktelement 2, das als Federkontakt ausgeführt ist. Das Kontaktelement 2 wird bereits vor Einsetzen der dritten Scheibe 21 in der Nut 17 angebracht. Die dritte Scheibe 21 wird so in die Nut 17 eingesetzt, dass der Sammelleiter 22 in Richtung des Kontaktelementes 2 weist. Der Federkontakt wird bei Einsetzen der dritten Scheibe 21 gegen den Sammelleiter 22 gepresst, wodurch die gewünschte elektrische Kontaktierung zustande kommt. Die Nut enthält ferner eine Einlage 24, die die Kante der dritten Scheibe 21 umschließt und sich bündig in die Nut 17 einpasst. Die Einlage 24 besteht aus Ethylen-Propylen-Dien-Kautschuk und ist im Bereich des Kontaktelements 2 ausgespart. Die Einlage 24 fixiert die dritte Scheibe 21 spannungsfrei und kompensiert eine Wärmeausdehnung der Scheibe. Des Weiteren verhindert die Einlage 24 eine Geräuschentwicklung durch Verrutschen der dritten Scheibe 21. Die Isolierverglasung II gemäß Figur 3 ermöglicht eine für den Betrachter unsichtbare elektrische Kontaktierung des elektrisch schaltbaren Funktionselementes, wobei auch der Sammelleiter 22 vollständig innerhalb der Nut 17 liegt und von dieser verdeckt wird.

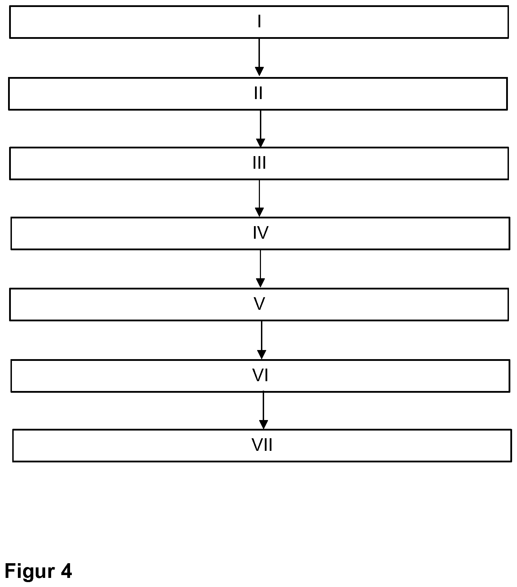

Figur 4 zeigt ein Fließdiagramm einer möglichen Ausführungsform des erfindungsgemäßen Verfahrens umfassend die Schritte:
- I: Coextrusion eines polymeren Abstandhalters I mit integrierter elektrischer Zuleitung 14,
- II: Vorfertigung eines umlaufenden Abstandhalterrahmens,
- III: Erstellen mindestens einer Austrittsöffnung 16 in der Wandung des Grundkörpers 5 und Herausführen der elektrischen Zuleitung 14 aus dem Grundkörper 5,
- IV: Anbringen einer Scheibe mit elektrisch schaltbarem Funktionselement 1 am Abstandhalter I und elektrische Kontaktierung von elektrischer Zuleitung 14 und Funktionselement 1,
- V: Anbringen mindestens einer weiteren Scheibe am Abstandhalter,
- VI: Verpressen der Scheibenanordnung und
- VII: Einbringen einer äußeren Abdichtung 6 in den äußeren Scheibenzwischenraum 13.

In einer bevorzugten Ausführungsform wird die elektrische Zuleitung 14 in Schritt I stoffschlüssig an der Innenwandung des polymeren Grundkörpers 5 angebracht. Dabei wird ein metallischer Leiter als elektrische Zuleitung 14 mittels des Extrusionswerkzeugs während der Extrusion kontinuierlich in die Hohlkammer eingelegt, wobei der metallische Leiter das Material des polymeren Grundkörpers 5 berührt und dadurch nach Erstarren des Kunststoffs stoffschlüssig mit diesem verbunden ist.

In Schritt IV wird im Fall einer Doppelverglasung eine erste Scheibe 19 oder zweite Scheibe 20 mit elektrochromem Funktionselement über ein Dichtmittel 4 an einer Scheibenkontaktfläche 7 des Abstandhalters I angebracht. Das elektrochrome Funktionselement ist dabei in Richtung des späteren Verglasungsinnenraums 3 gerichtet. In Schritt V wird daraufhin die zweite Scheibe 20 ebenfalls über ein Dichtmittel 4 an der noch zur Verfügung stehenden Scheibenkontaktfläche 7 angebracht.

Handelt es sich um eine Dreifachverglasung mit Doppelabstandhalter, so wird in Schritt IV eine dritte Scheibe 21 in die Nut 17 des Abstandhalters I eingesetzt und in Schritt V die erste und die zweite Scheibe 19 und 20 über ein Dichtmittel 4 an den Scheibenkontaktflächen 7 angebracht.

### Bezugszeichenliste

- I: Abstandhalter
- II: Isolierverglasung
- 1: elektrisch schaltbares Funktionselement
- 2: Kontaktelement
- 3: Verglasungsinnenraum
- 4: Dichtmittel
- 5: polymerer Grundkörper
- 6: äußere Abdichtung
- 7: Scheibenkontaktflächen
- 7.1: erste Scheibenkontaktfläche
- 7.2: zweite Scheibenkontaktfläche
- 8: Verglasungsinnenraumfläche
- 9: Außenfläche
- 10: Hohlkammern
- 10.1: erste Hohlkammer
- 10.2: zweite Hohlkammer
- 11: Trockenmittel
- 12: Öffnungen
- 13: äußerer Scheibenzwischenraum
- 14: elektrische Zuleitung
- 15: Eintrittsöffnung
- 16: Austrittsöffnung
- 17: Nut
- 18: Isolierung
- 19: erste Scheibe
- 20: zweite Scheibe
- 21: dritte Scheibe
- 22: Sammelleiter
- 23: Spannungsquelle
- 24: Einlage

## Patentansprüche

1. Abstandhalter (I) mit integrierter elektrischer Zuleitung (14) für Isolierverglasungen mindestens umfassend
- einen Grundkörper (5) umfassend zwei Scheibenkontaktflächen (7.1, 7.2), eine Verglasungsinnenraumfläche (8), eine Außenfläche (9), eine Hohlkammer (10) und
- eine elektrische Zuleitung (14) innerhalb der Hohlkammer (10),
wobei die elektrische Zuleitung (14) in die Hohlkammer (10) eintritt, in mindestens einem Abschnitt längs der Hohlkammer (10), im Wesentlichen parallel zu den Scheibenkontaktflächen (7.1, 7.2), verläuft und über mindestens eine Austrittsöffnung (16) in der Wandung des Grundkörpers (5) austritt, **dadurch gekennzeichnet, dass** der Grundkörper (5) ein polymerer Grundkörper ist und die elektrische Zuleitung (14) an der Innenwandung des polymeren Grundkörpers (5) stoffschlüssig angebunden ist.

2. Abstandhalter (I) nach Anspruch 1, wobei die elektrische Zuleitung (14) durch eine Eintrittsöffnung (15) in der Außenfläche (9) des Abstandhalters (I) in die Hohlkammer (10) eintritt.

3. Abstandhalter (I) nach Anspruch 1, wobei die elektrische Zuleitung (14) durch einen offenen Querschnitt des Grundkörpers (5) in die Hohlkammer (10) eintritt.

4. Abstandhalter (I) nach einem der Ansprüche 1 bis 3, wobei die elektrische Zuleitung (14) die Hohlkammer (10) in einem Abschnitt mit einer Länge von mindestens 10 cm, bevorzugt von mindestens 20 cm, besonders bevorzugt mindestens 30 cm durchläuft.

5. Abstandhalter (I) nach einem der Ansprüche 1 bis 4, wobei die elektrische Zuleitung (14) durch eine Austrittsöffnung (16) in der Verglasungsinnenraumfläche (8) und/oder durch eine Austrittsöffnung (16) in mindestens einer der Scheibenkontaktflächen (7.1, 7.2) austritt.

6. Abstandhalter (I) nach einem der Ansprüche 1 bis 5, wobei der Abstandhalter (I) eine Nut (17) zur Aufnahme einer Scheibe umfasst, die parallel zur ersten Scheibenkontaktfläche (7.1) und zweiten Scheibenkontaktfläche (7.2) verläuft, und eine erste Hohlkammer (10.1) an die Nut (17) und die erste Scheibenkontaktfläche (2.1) angrenzt und eine zweite Hohlkammer (10.2) an die Nut (17) und die zweite Scheibenkontaktfläche (2.2) angrenzt, und wobei
die elektrische Zuleitung (14) durch eine Austrittsöffnung (16) in die Nut (17) eintritt.

7. Isolierverglasung (II) mindestens umfassend eine erste Scheibe (19) und eine zweite Scheibe (20) und einen die Scheiben umfassenden umlaufenden Abstandhalter (I) nach einem der Ansprüche 1 bis 6,
wobei
- die erste Scheibe (19) an der ersten Scheibenkontaktfläche (7.1) anliegt,
- die zweite Scheibe (20) an der zweiten Scheibenkontaktfläche (7.2) anliegt,
- die elektrische Zuleitung (14) durch die Austrittsöffnung (16) in den Verglasungsinnenraum (3) zwischen erster Scheibe (19), zweiter Scheibe (20) und Abstandhalter (I) eintritt und
- die elektrische Zuleitung (14) ein elektrisch schaltbares Funktionselement (1) im Verglasungsinnenraum (3) elektrisch leitend kontaktiert.

8. Isolierverglasung (II) mindestens umfassend eine erste Scheibe (19), eine zweite Scheibe (20) und eine dritte Scheibe (21) und einen die Scheiben umfassenden umlaufenden Abstandhalter (I) nach Anspruch 6,
wobei
- die erste Scheibe (19) an der ersten Scheibenkontaktfläche (7.1) anliegt,
- die zweite Scheibe (20) an der zweiten Scheibenkontaktfläche (7.2) anliegt,
- die dritte Scheibe (21) in die Nut (17) des Abstandhalters (I) eingesetzt ist,
- die dritte Scheibe (21) ein elektrisch schaltbares Funktionselement (1) umfasst und
- die elektrische Zuleitung (14) das elektrisch schaltbare Funktionselement (1) innerhalb der Nut (17) elektrisch leitend kontaktiert.

9. Isolierverglasung (II) nach Anspruch 7 oder 8, wobei die elektrische Zuleitung (14) das elektrisch schaltbare Funktionselement (1) über ein Kontaktelement (2), bevorzugt über einen Federkontakt, elektrisch leitend kontaktiert.

10. Isolierverglasung (II) nach einem der Ansprüche 7 bis 9, wobei der Abstandhalter (I) an den Ecken der Isolierverglasung (II) gebogen ist und die mindestens eine Hohlkammer (10) des Abstandhalters (I) umlaufend entlang des Abstandhalters (I) durchgängig ist.

11. Verfahren zur Herstellung einer Isolierverglasung (II) nach einem der Ansprüche 7 bis 10, wobei zumindest
a) ein Abstandhalter (I) mit integrierter elektrischer Zuleitung (14) bereitgestellt wird,
b) der Abstandhalter (I) mittels eines Dichtmittels (4) über jeweils eine Scheibenkontaktfläche (7.1, 7.2) zwischen einer ersten Scheibe (1) und einer zweiten Scheibe (2) angebracht wird und ein elektrisch schaltbares Funktionselement (1) in den Verglasungsinnenraum (3) eingebracht wird,
c) die Anordnung verpresst wird und
d) in den äußeren Scheibenzwischenraum (13) eine äußere Abdichtung (6) eingebracht wird,
wobei die elektrische Zuleitung (14) in Schritt b) elektrisch leitend mit dem elektrisch schaltbaren Funktionselement (1) kontaktiert wird.

12. Verfahren nach Anspruch 11, wobei vor Schritt b) eine dritte Scheibe (21) in eine Nut (17) des Abstandhalters (I) eingesetzt wird.

13. Verwendung eines Abstandshalters (I) nach einem der Ansprüche 1 bis 6 in Isolierverglasungen (II) umfassend elektrisch schaltbare Funktionselemente (22), bevorzugt umfassend die ein SPD-, ein PDLC-, ein elektrochromes oder ein elektrolumineszentes Funktionselement.

## Claims

1. Spacer (I) having an integrated electric feed line (14) for insulating glazings at least comprising
- a main body (5) comprising two pane contact surfaces (7.1, 7.2), a glazing interior surface (8), an outer surface (9), a hollow chamber (10), and
- an electric feed line (14) within the hollow chamber (10),
wherein the electric feed line (14) enters the hollow chamber (10), runs substantially parallel to the pane contact surfaces (7.1, 7.2) in at least one section along the hollow chamber (10), and exits via at least one exit opening (16) in the wall of the main body (5),
**characterized in that**
the main body (5) is a polymeric main body, and the electric feed line (14) is materially bonded to the inner wall of the polymeric main body (5).

2. Spacer (I) according to claim 1, wherein the electric feed line (14) enters the hollow chamber (10) through an entry opening (15) in the outer surface (9) of the spacer (I).

3. Spacer (I) according to claim 1, wherein the electric feed line (14) enters the hollow chamber (10) through an open cross-section of the main body (5).

4. Spacer (I) according to one of claims 1 through 3, wherein the electric feed line (14) runs through the hollow chamber (10) in a section with a length of at least 10 cm, preferably of at least 20 cm, particularly preferably at least 30 cm.

5. Spacer (I) according to one of claims 1 through 4, wherein the electric feed line (14) exits through an exit opening (16) in the glazing interior surface (8) and/or through an exit opening (16) in at least one of the pane contact surfaces (7.1, 7.2).

6. Spacer (I) according to one of claims 1 through 5, wherein the spacer (I) includes a groove (17) for receiving a pane, which extends parallel to the first pane contact surface (7.1) and the second pane contact surface (7.2), and a first hollow chamber (10.1) is adjacent the groove (17) and the first pane contact surface (2.1), and a second hollow chamber (10.2) is adjacent the groove (17) and the second pane contact surface (2.2), and wherein
the electric feed line (14) enters the groove (17) through an exit opening (16).

7. Insulating glazing (II) at least comprising a first pane (19) and a second pane (20) and a circumferential spacer (I) according to one of claims 1 through 6 surrounding the panes,
wherein
- the first pane (19) rests against the first pane contact surface (7.1),
- the second pane (20) rests against the second pane contact surface (7.2),
- the electric feed line (14) enters the glazing interior (3) between the first pane (19), the second pane (20), and the spacer (I) through the exit opening (16), and
- the electric feed line (14) makes electrically conductive contact with an electrically switchable functional element (1) in the glazing interior (3).

8. Insulating glazing (II) at least comprising a first pane (19), a second pane (20), and a third pane (21) and a circumferential spacer (I) according to claim 6 surrounding the panes,
wherein
- the first pane (19) rests against the first pane contact surface (7.1),
- the second pane (20) rests against the second pane contact surface (7.2),
- the third pane (21) is inserted into the groove (17) of the spacer (I),
- the third pane (21) includes an electrically switchable functional element (1), and
- the electric feed line (14) makes electrically conductive contact with the electrically switchable functional element (1) within the groove (17).

9. Insulating glazing (II) according to claim 7 or 8, wherein the electric feed line (14) makes electrically conductive contact with the electrically switchable functional element (1) via a contact element (2), preferably via a spring contact

10. Insulating glazing (II) according to one of claims 7 through 9, wherein the spacer (I) is bent at the corners of the insulating glazing (II) and the at least one hollow chamber (10) of the spacer (I) is continuous circumferentially along the spacer (I).

11. Method for producing an insulating glazing (II) according to one of claims 7 through 10, wherein at least
a) a spacer (I) having an integrated electric feed line (14) is provided,
b) the spacer (I) is attached by means of a sealant (4) via a pane contact surface (7.1, 7.2) in each case between a first pane (1) and a second pane (2), and an electrically switchable functional element (1) is inserted into the glazing interior (3),
c) the assembly is pressed, and
d) an outer seal (6) is introduced into the outer interpane space (13),
wherein, in step b), the electric feed line (14) makes electrically conductive contact with the electrically switchable functional element (1).

12. Method according to claim 11, wherein, before step b), a third pane (21) is inserted into a groove (17) of the spacer (I).

13. Use of a spacer (I) according to one of claims 1 through 6, in insulating glazings (II) including electrically switchable functional elements (22), preferably including an SPD, a PDLC, an electrochromic, or an electroluminescent functional element.

## Revendications

1. Dispositif d'écartement (I) avec ligne d'alimentation électrique intégrée (14) pour vitrages isolants, comportant au moins :
- un corps de base (5) comportant deux surfaces de contact de vitre (7.1, 7.2), une surface d'espace interne de vitrage (8), une surface externe (9), une chambre creuse (10) ; et
- une ligne d'alimentation électrique (14) à l'intérieur de la chambre creuse (10),
dans lequel la ligne d'alimentation électrique (14) entre dans la chambre creuse (10), s'étend dans au moins une section le long de la chambre creuse (10), sensiblement parallèlement aux surfaces de contact de vitre (7.1, 7.2), et sort par au moins une ouverture de sortie (16) dans la paroi du corps de base (5),
**caractérisé par le fait que**
le corps de base (5) est un corps de base polymère et la ligne d'alimentation électrique (14) est reliée par liaison de matière à la paroi interne du corps de base polymère (5) .

2. Dispositif d'écartement (I) selon la revendication 1, dans lequel la ligne d'alimentation électrique (14) entre dans la chambre creuse (10) par une ouverture d'entrée (15) dans la surface externe (9) du dispositif d'écartement (I).

3. Dispositif d'écartement (I) selon la revendication 1, dans lequel la ligne d'alimentation électrique (14) entre dans la chambre creuse (10) par une section transversale ouverte du corps de base (5).

4. Dispositif d'écartement (I) selon l'une des revendications 1 à 3, dans lequel la ligne d'alimentation électrique (14) passe à travers la chambre creuse (10) dans une section ayant une longueur d'au moins 10 cm, de préférence d'au moins 20 cm, de façon particulièrement préférée d'au moins 30 cm.

5. Dispositif d'écartement (I) selon l'une des revendications 1 à 4, dans lequel la ligne d'alimentation électrique (14) sort par une ouverture de sortie (16) dans la surface d'espace interne de vitrage (8) et/ou par une ouverture de sortie (16) dans au moins l'une des surfaces de contact de vitre (7.1, 7.2).

6. Dispositif d'écartement (I) selon l'une des revendications 1 à 5, dans lequel le dispositif d'écartement (I) comporte une rainure (17) pour recevoir une vitre, qui s'étend parallèlement à la première surface de contact de vitre (7.1) et à la seconde surface de contact de vitre (7.2), et une première chambre creuse (10.1) est adjacente à la rainure (17) et à la première surface de contact de vitre (2.1) et une seconde chambre creuse (10.2) est adjacente à la rainure (17) et à la seconde surface de contact de vitre (2.2), et dans lequel
la ligne d'alimentation électrique (14) entre dans la rainure (17) par une ouverture de sortie (16).

7. Vitrage isolant (II) comportant au moins une première vitre (19) et une deuxième vitre (20) et un dispositif d'écartement périphérique (I) selon l'une des revendications 1 à 6, entourant les vitres,
dans lequel :
- la première vitre (19) s'appuie sur la première surface de contact de vitre (7.1) ;
- la seconde vitre (20) s'appuie sur la seconde surface de contact de vitre (7.2) ;
- la ligne d'alimentation électrique (14) entre par l'ouverture de sortie (16) dans l'espace interne de vitrage (3) entre la première vitre (19), la seconde vitre (20) et le dispositif d'écartement (I) ; et
- la ligne d'alimentation électrique (14) établit un contact électriquement conducteur avec un élément fonctionnel électriquement commutable (1) dans l'espace interne de vitrage (3).

8. Vitrage isolant (II) comportant au moins une première vitre (19), une deuxième vitre (20) et une troisième vitre (21) et un dispositif d'écartement périphérique (I) selon la revendication 6, entourant les vitres,
dans lequel :
- la première vitre (19) s'appuie sur la première surface de contact de vitre (7.1) ;
- la deuxième vitre (20) s'appuie sur la deuxième surface de contact de vitre (7.2) ;
- la troisième vitre (21) est introduite dans la rainure (17) du dispositif d'écartement (I) ;
- la troisième vitre (21) comporte un élément fonctionnel électriquement commutable (1) ; et
- la ligne d'alimentation électrique (14) établit un contact électriquement conducteur avec l'élément fonctionnel électriquement commutable (1) à l'intérieur de la rainure (17).

9. Vitrage isolant (II) selon l'une des revendication 7 ou 8, dans lequel la ligne d'alimentation électrique (14) établit un contact électriquement conducteur avec l'élément fonctionnel électriquement commutable (1) par l'intermédiaire d'un élément de contact (2), de préférence par l'intermédiaire d'un contact à ressort.

10. Vitrage isolant (II) selon l'une des revendications 7 à 9, dans lequel le dispositif d'écartement (I) est incurvé aux coins du vitrage isolant (II) et ladite au moins une chambre creuse (10) du dispositif d'écartement (I) est continue périphériquement le long du dispositif d'écartement (I).

11. Procédé de fabrication d'un vitrage isolant (II) selon l'une des revendications 7 à 10, dans lequel au moins
a) un dispositif d'écartement (I) avec ligne d'alimentation électrique intégrée (14) est fourni ;
b) le dispositif d'écartement est appliqué au moyen d'un matériau d'étanchéité (4) sur une surface de contact de vitre respective (7.1, 7.2) entre une première vitre (1) et une deuxième vitre (2) et un élément fonctionnel électriquement commutable (1) est introduit dans l'espace interne de vitrage (3) ;
c) l'ensemble est comprimé ; et
d) une garniture d'étanchéité externe (6) est introduite dans l'espace externe (13) entre les vitres,
dans lequel à l'étape b), la ligne d'alimentation électrique (14) établit un contact électriquement conducteur avec l'élément fonctionnel électriquement commutable (1).

12. Procédé selon la revendication 11, dans lequel, avant l'étape b), une troisième vitre (21) est introduite dans une rainure (17) du dispositif d'écartement (I) .

13. Utilisation d'un dispositif d'écartement (I) selon l'une des revendications 1 à 6 dans des vitrages isolants (II) comportant des éléments fonctionnels électriquement commutables (22), comportant de préférence un élément fonctionnel SPD, un élément fonctionnel PDLC, un élément fonctionnel électrochrome ou un élément fonctionnel électroluminescent.
